# EUROPÄISCHE PATENTSCHRIFT

(11) **EP 2 699 378 B1**
(45) Veröffentlichungstag und Bekanntmachung des Hinweises auf die Patenterteilung: **16.09.2015**
(21) Anmeldenummer: 13717478.5
(22) Anmeldetag: 11.04.2013
(51) Int. Cl.: B23K 26/06, B23K 26/073, B23K 26/08, G02B 27/09

(54) **OPTISCHES SYSTEM FÜR EINE ANLAGE ZUR BEARBEITUNG VON DÜNNFILMSCHICHTEN**
OPTICAL SYSTEM FOR AN INSTALLATION FOR PROCESSING THIN-FILM LAYERS
SYSTÈME OPTIQUE POUR UNE INSTALLATION DESTINÉE À TRAITER DES COUCHES DE FILM MINCE

(30) Priorität: 16.04.2012 DE 102012007601
(43) Veröffentlichungstag der Anmeldung: 26.02.2014
(73) Patentinhaber: Innovavent GmbH, 37085 Göttingen (DE)
(72) Erfinder: BURGHARDT, Berthold, 37136 Waake (DE); KAHLERT, Hans-Jürgen, 37077 Göttingen (DE)
(74) Vertreter: Frenkel, Matthias Alexander
(86) Internationale Anmeldenummer: PCT/EP2013/057580
(87) Internationale Veröffentlichungsnummer: WO 2013/156384

(56) Entgegenhaltungen:
- US-A1- 2003 196 996

## Beschreibung

Die Erfindung betrifft ein optisches System gemäß dem Oberbegriff des Anspruchs 1. Das Dokument US 2003/0196 996 A1 offenbart solch ein optisches System.

Für die Kristallisation von Dünnfilmschichten beispielsweise für die Herstellung von Dünnfilmtransistoren (im Englischen: Thin Film Transistor; kurz: TFT) werden Laser eingesetzt. Als zu bearbeitender Halbleiter kommt insbesondere Silizium (kurz: Si), genauer a-Si zum Einsatz. Die Dicke der Halbleiterschicht beträgt z.B. 50nm, welche sich typischerweise auf einem Substrat (z.B. Glassubstrat) oder einem sonstigen Träger befindet.

Die Schicht wird mit dem Licht des Lasers, beispielsweise eines Excimerlasers beleuchtet. Dabei wird das Licht mit einer Wellenlänge von z.B. 308nm in eine Beleuchtungslinie geformt, siehe z. B. DE 19 520 187. Die Beleuchtungslinie weist eine kurze Achse und eine lange Achse auf. Die lange Achse hat beispielsweise eine Länge von bis zu 750mm und länger. Die kurze Achse ist typischerweise 300 bis 400µm schmal. Die Beleuchtungslinie weist also ein hohes Aspektverhältnis aus kurzer und langer Achse auf.

Diese Beleuchtungslinie wird mit einem Vorschub von ca. 1 bis 50 mm/s, vorzugsweise 10 bis 20mm/s in Richtung der kurzen Achse über die Halbleiterschicht geführt. Die Intensität (im Fall von Dauerstrichlasern) bzw. die Pulsenergie (im Fall von gepulsten Lasern) des Lichtstrahls wird derart eingestellt, dass die Halbleiterschicht kurzzeitig (d.h. auf einer Zeitskala von etwa 50 bis 100ns) aufschmilzt und sich als kristalline Schicht mit verbesserten elektrischen Eigenschaften wieder verfestigt. Im Fall von Si beispielsweise entsteht eine sog. LTPS-Schicht (Low Temperature Poly Silicon). Hierdurch wird die Mobilität der Elektronen in der Schicht beispielsweise von 0,5cm²/Vs auf 100cm²/Vs und mehr erhöht.

Anstatt eines Excimerlasers kann/können ein oder mehrere Festkörperlaser zum Einsatz kommen. Festkörperlaser haben im Vergleich zu Excimerlasern den Vorteil, dass sie weniger wartungsintensiv sind und damit geringere Wartungskosten verursachen. Kommerziell sind bereits Festkörperlaser verfügbar, die im Pulsbetrieb eine gepulste oder im Dauerstrichbetrieb eine kontinuierliche Laserstrahlung im Wellenlängenbereich von 510 bis 540nm mit ausreichender Leistung bzw. Pulsenergie erzeugen. Der Einsatz solchen Lichts erlaubt es insbesondere, p-Si-Schichten zu erzeugen, die ebenso für die Herstellung von TFTs in Displays geeignet sind. Darüber hinaus erlauben Festkörperlaser im Pulsbetrieb eine hohe Repetitionsrate von typischerweise 10kHz oder mehr, was bei einem langsamen Vorschub von etwa 1 bis 2µm pro Puls (d.h. etwa 10 bis 20mm/s bei einer Repetitionsrate von 10 kHz) die Erzeugung sehr uniformer Schichten mit vergleichmäßigten Schichteigenschaften ermöglicht. Auch sind bereits gepulste UV-Festkörperlasern bekannt, die Licht mit einer Wellenlänge von z.B. 355nm emittieren. Derzeit liefert ein einzelner UV-Festkörperlaser jedoch noch zu geringe Leistungen bzw. Pulsenergien zur Halbleiterschichtbearbeitung. Daher ist es notwendig, die Leistung bzw. Pulsenergie mehrerer solcher Festkörperlaser zu einer Beleuchtungslinie zu vereinen.

Die Qualität der erzeugten Beleuchtungslinie hängt von mehreren Faktoren ab: Gewünscht ist zum einen eine möglichst homogene Intensitätsverteilung. Insbesondere durch die Kohärenz des Laserlichts verursachte Interferenzerscheinungen innerhalb der Beleuchtungslinie gilt es zu unterdrücken. Auch sollte die Intensitätsverteilung keinen zeitlich variierenden Veränderungen (im Englischen: drifts) unterworfen sein, wie sie beispielsweise durch Leistungsschwankungen einer zu knapp bemessenen Laserlichtquelle verursacht sein können. Zum anderen sollten zeitliche oder temperaturbedingte Drifts in der räumlichen Position (im Englischen: beam pointing), der Ausrichtung und der Form der Beleuchtungslinie vermieden werden. Insgesamt ist es wünschenswert, bei der Erzeugung der Beleuchtungslinie eine an die Eigenschaften der Beleuchtungslinie angepasste Verarbeitung (d.h. Verformung, Strahlführung, Strahlprofilmanipulation, Strahlparameterproduktmanipulation, usw.) des ursprünglichen Lichtstrahls vorzunehmen, um so die Eigenschaften der Beleuchtungslinie zu optimieren.

Das Dokument US 2007/0237457 A1 betrifft eine Laserbestrahlungsvorrichtung zur Kristallisation in Dünnfilmtransistoren. Die Vorrichtung umfasst mehrere teilreflektierender Spiegel zur Aufspaltung eines Laserstrahls in mehrere Teillaserstrahlen, mehrere optische Fasern zum Transport der Teillaserstrahlen und ein optisches System zur Homogenisierung und Fokussierung der aus den optischen Fasern austretenden Laserstrahlen auf eine Beleuchtungslinie.

Das Dokument US 2003/0196996 A1 betrifft eine Vorrichtung zur thermischen Bearbeitung eines Substrats mit Hilfe einer Strahlungslinie. Hierbei wird Strahlung aus einer Strahlungsquelle über ein Prisma auf mehrere optische Fasern gerichtet und die aus den optischen Fasern austretende Strahlung anhand einer Linse auf eine Strahlungslinie fokussiert.

Das Dokument WO 2009/012913 A1 betrifft eine Anordnung zur Erzeugung von Multistrahlen. Dabei wird ein von einer Laserstrahlquelle ausgehendes Strahlungsfeld durch diskret angeordnete optische Komponenten in mindestens zwei Strahlen unterteilt, die jeweils in einen Lichtwellenleiter eingekoppelt werden. Die Lichtwellenleiter bilden ein ein- oder zweidimensionales Lichtwellenleiterarray und weisen im Wesentlichen rechteckförmige Querschnitte auf.

Das Dokument WO 00/57229 betrifft eine optische Vorrichtung, die Dioden-Stacks jeweils zur Erzeugung einer einzelnen "Linienquelle" verwendet, welche über optische Elemente in eine entsprechende optische Faser eingekoppelt werden. Eine Fokussierlinse fokussiert die aus den optischen Fasern austretenden "Linienquellen" auf einen einzelnen rechteckigen Punkt.

Eine Aufgabe von Ausführungsformen der Erfindung ist es daher, ein optisches System für eine Anlage zur Bearbeitung von Dünnfilmschichten oder einzelne Sub-Module (d.h. Komponenten) eines solchen optischen Systems anzugeben, welche dazu beitragen, die Qualität einer aus Licht geformten Beleuchtungslinie zu gewährleisten und/oder zu verbessern.

Diese Aufgabe wird anhand eines optischen Systems nach Anspruch 1 gelost.

Gemäß vorteilhafter Ausführungsformen umfasst ein optisches System für eine Anlage zur Bearbeitung von Dünnfilmschichten eine Mehrzahl N (also N=2, 3, 4, ....; Allgemein N≥2) Lichtleitfasern zum Leiten von Licht, insbesondere Laserlicht, sowie mindestens eine optische Einkopplungseinrichtung zum Einkoppeln des Lichts in die Lichtleitfasern und/oder eine optische Abbildungseinrichtung zur Erzeugung einer mit aus den Lichtleitfasern austretenden Lichtstrahlen gebildeten, eine lange Achse und eine kurze Achse aufweisenden Beleuchtungslinie in einer Beleuchtungsebene.

Die grundsätzlichen Vorteile eines solchen optischen Systems sind die folgenden.

Die optische Einkopplungseinrichtung zum Einkoppeln des Lichts in die mehreren Lichtleitfasern erlaubt es beispielsweise, das Licht einer (einzigen) Lichtquelle über mehrere Lichtleitfasern zur Beleuchtungslinie zu transportieren. Da Lichtleitfasern bekanntermaßen nur für endliche Lichtleistungen bzw. Pulsenergien ausgelegt sind, kann es von Vorteil sein, das von der Lichtquelle abgegebene Licht über mehrere Lichtleitfasern verteilt zu transportieren, um somit zu verhindern, dass die Lichtleitfaser einer zu hohen Beanspruchung ausgesetzt sind und damit verschleißen oder zerstört werden. Die Eigenschaften der Lichtleitfasern bleiben dadurch dauerhaft gewahrt. Insgesamt kann demnach die optisch Einkopplungseinrichtung für sich genommen dazu beitragen, die Qualität der Beleuchtungslinie langfristig zu erhalten und damit zu verbessern.

Auch der Einsatz der Lichtleitfasern selbst bringt Vorteile mit sich: Wird Licht in einer Lichtleitfaser geführt, erzeugen die Lichtleitfasern aufgrund ihrer Eigenschaft der Lichtmodenreinigung beim Transport des Lichts innerhalb der Lichtleitfaser ausgangsseitig eine zeitlich konstante Modenzusammensetzung mit fester räumlicher Position, Ausrichtung und Form. Somit kann die Verwendung der Lichtleitfasern dazu beitragen, Drifts in der räumlichen Position, der Ausrichtung und der Form der Beleuchtungslinie zu vermeiden. Folglich verbessern auch die Lichtleitfasern die Qualität der aus Licht geformten Beleuchtungslinie. Die Lichtleitfasern ermöglichen zudem eine Entkopplung zwischen optischer Einkopplungseinrichtung und optischer Abbildungseinrichtung, was eine unabhängige Justage dieser beiden Einrichtungen erlaubt.

Außerdem können die Längen der Lichtleitfasern untereinander derart unterschiedlich gewählt sein, dass Längenunterschiede zwischen den Lichtleitfasern jeweils größer sind als die Kohärenzlänge des zu transportierenden Lichts. Bei der Überlagerung der aus den Lichtleitfasern austretenden Lichtstrahlen zur Beleuchtungslinie können damit Interferenzerscheinungen im Intensitätsmuster der Beleuchtungslinie vermieden werden. Auch unter diesen Umständen können die Lichtleitfasern zu einer Verbesserung der Qualität der Beleuchtungslinie beitragen.

Ein weiterer Vorteil: Da es sich um eine Mehrzahl an Lichtleitfasern handelt, können beispielsweise die Faserenden der Lichtleitfasern, aus denen die Lichtstrahlen austreten, derart zueinander angeordnet werden, dass sie der räumlichen Geometrie der Beleuchtungslinie angepasst sind. Denkbar ist, dass die Gesamtheit der durch die aus den Lichtleitfasern austretenden Lichtstrahlen gebildeten Modenprofile in ihrer Form an die Beleuchtungslinie mit deren von null verschiedenem Aspektverhältnis angenähert ist. Somit beginnt bereits bei Austritt der Lichtstrahlen aus den Lichtleitfasern eine auf die Formung der Beleuchtungslinie angepasste Lichtverarbeitung. Diese Vorab-Lichtformung durch das Arrangement der Lichtleitfasern zueinander ergänzt damit die mit der optischen Abbildungseinrichtung bewirkte Lichtformung und kann damit letztendlich auch zur Qualitätsverbesserung der Beleuchtungslinie beitragen.

Schließlich erlaubt die optische Abbildungseinrichtung die Verarbeitung der aus den Lichtleitfasern austretenden Lichtstrahlen zur Beleuchtungslinie: Die optische Abbildungseinrichtung ist dazu eingerichtet, aus den Lichtstrahlen, welche aus den mehreren Lichtleitfasern austreten, die Beleuchtungslinie zu formen. Die geometrische Form der Beleuchtungslinie ist anhand einer kurzen und einer langen Achse charakterisiert. Somit erlaubt die optische Abbildungseinrichtung beispielsweise die Formung einer Beleuchtungslinie mit einem von eins verschiedenem Aspektverhältnis Y_{B} (d.h. Y_{B}≠1). Die Beleuchtungslinie kann die Form eines Rechtecks aufweisen. Die Beleuchtungslinie ist aber auch als eine an ein Rechteck angenäherte Form (rechteckförmig) realisierbar. Die Geometrie der Beleuchtungslinie kann damit gezielt eingestellt werden, weshalb auch auf die Qualität der Beleuchtungslinie Einfluss genommen werden kann.

Weitere Vorteile ergeben sich aus den nachfolgend beschriebenen möglichen Weiterbildungen des optischen Systems bzw. dessen Komponenten.

Alle Lichtleitfasern können identisch ausgebildet sein. Jede Lichtleitfaser kann durch die Geometrie des Querschnitts der Lichtleitfaser und die numerische Apertur der Lichtleitfaser charakterisiert werden. Die Geometrie des Querschnitts bestimmt sich typischerweise durch die Geometrie des Kerns und/oder des Mantels der Lichtleitfaser. Die Geometrie kann insbesondere anhand einer ersten Faserachse der Länge L_{F1} und einer zur ersten Faserachse senkrechten zweiten Faserachse der Länge L_{F2} charakterisiert werden. Die Länge L_{F1} im Verhältnis zur Länge L_{F2} definiert ein Aspektverhältnis L_{F1}:L_{F2}=Y_{F}:1=Y_{F}.

Eine Lichtleitfaser weist ein Aspektverhältnis von Y_{F}≠1 auf, d.h. L_{F1}≠L_{F2}. Hierzu weist die Lichtleitfaser einen rechteckförmigen Querschnitt auf. Man spricht dann von einer Rechteckfaser. In diesem Fall entspricht der ersten Faserachse eine lange Achse der Länge L_{F1} und der zweiten Faserachse eine kurze Achse der Länge L_{F2} mit L_{F1}=Y_{F}xL_{F2} oder umgekehrt.

Die numerische (Eingangs- und Ausgangs-)Apertur NA_{F} einer Lichtleitfaser bestimmt sich typischerweise aus dem optischen Brechungsindex n_{K} des Kerns und/oder dem optischen Brechungsindex n_{M} des Mantels der Lichtleitfaser, NA_{F}=(n_{K}²+n_{M}²)^{1/2}. Die numerische Apertur NA_{F} korrespondiert gemäß NA_{F}=nxsin(θₘₐₓ) zum maximalen Akzeptanzwinkel θₘₐₓ der Lichtleitfaser, der den halben Winkel des Eintritts- bzw. Austrittskegels der Lichtleitfaser definiert und bei dem noch Totalreflexion des Lichts innerhalb der Lichtleitfaser auftritt.

Anhand der Parameter L_{F1}, L_{F2} und NA_{F} können der Faser für die erste und die zweite Faserachse jeweils ein Strahlparameterprodukt zugeordnet werden: SPP_{Fi}=arcsin(NA_{F})xL_{Fi}/2, wobei i=1 oder 2.

Die Geometrie des Strahlprofils eines Lichtstrahls kann anhand einer ersten Strahlachse der Länge L_{L1} und einer zur ersten Strahlachse senkrechten zweiten Strahlachse der Länge L_{L2} charakterisiert werden. Im allgemein gilt L_{L1} ≠L_{L2}. Die Länge L_{L1} im Verhältnis zur Länge L_{L2} definiert ein Aspektverhältnis L_{L1}:L_{L2}=Y_{L}:1=Y_{L}. Zum Beispiel definiert L_{L1} bzw. L_{L2} die Positionen im Strahlprofil des Lichtstrahls entlang der ersten bzw. zweiten Strahlachse, bei der die Intensität des Lichtstrahls auf 1/e² oder ½ des Maximalwerts abgefallen ist.

Die Divergenz eines Lichtstrahls wird durch die Numerische Apertur NA_{L} oder durch den halben Fernfeldwinkel (=Divergenzwinkel) ϕ beschrieben, wobei NA_{L}=sin(ϕ). Die numerische Apertur NA_{L1} bezüglich der ersten Strahlachse des Lichtstrahls und die numerische Apertur NA_{L2} bezüglich der zweiten Strahlachse des Lichtstrahls können unterschiedlich sein, d.h. NA_{L1}≠NA_{L2}.

Die Parameter L_{L1} und NA_{L1} bzw. L_{L2} und NA_{L2} eines Lichtstrahls bestimmen ein Strahlparameterprodukt SPP_{L1} für die erste Strahlachse und ein Strahlparameterprodukt SPP_{L2} für die zweite Strahlachse des Lichtstrahls. Das Strahlparameterprodukt ist definiert als SPPLi=arcsin(NA_{Li})xL_{Li}/2=M_{Li}²xλ/π, wobei i=1 oder 2, M_{Li}² die Beugungsmaßzahl des Lichtstrahls bezüglich der ersten bzw. zweiten Strahlachse des Lichtstrahls und A die Wellenlänge des Lichtstrahls ist. Die Beugungsmaßzahl M² ist ein Maß für die Fokussierbarkeit des Lichtstrahls. Die Beugungsmaßzahl M_{L1}² bezüglich der ersten Strahlachse des Lichtstrahls und die Beugungsmaßzahl M_{L2}² bezüglich der zweiten Strahlachse des Lichtstrahls können unterschiedlich sein, d.h. M_{L1}² ≠M_{L2}².

Eine Lichtleitfaser hat typischerweise die Eigenschaft, beim Transport eines Lichtstrahls durch die Lichtleitfaser die numerischen Aperturen NA_{L1} und NA_{L2} des eingekoppelten Lichtstrahls zu mischen. Gilt etwa für den in die Lichtleitfaser eintretenden Lichtstrahl NA_{L1}>NA_{L2}, so wird der Lichtstrahl bei Austritt aus der Lichtleitfaser mit der größeren numerischen Apertur NA_{L1} sowohl entlang der ersten, als auch entlang der zweiten Faserachse emittiert. Dies gilt insbesondere bei Rechteckfasern.

Für eine effiziente Einkopplung eines Lichtstrahls in eine Lichtleitfaser ist es nötig, die Parameter L_{L1}, L_{L2}, NA_{L1}, NA_{L2}, SPP_{L1} und SPP_{L2} des Lichtstrahls vor bzw. bei Eintritt in die Lichtleitfaser an die entsprechenden Parameter L_{F1}, L_{F2}, NA_{F}, SPP_{F1} und SPP_{F2} der Lichtleitfaser anzupassen. Insbesondere ist es notwendig, die Parameter so auszuwählen, dass L_{L1}≤L_{F1}, L_{L2}≤L_{F2}, NA_{L1}≤NA_{F} und NA_{L2}≤NA_{F} sowie SPP_{L1}<SPP_{F1} und SPP_{L2}<SPP_{F1}, d.h. insbesondere sind die Strahlparameterprodukte SPP_{L1} und SPP_{L2} bezüglich der ersten und zweiten Strahlachsen des Lichtstrahls kleiner auszuwählen als die Strahlparameterprodukte SPP_{F1} bzw. SPP_{F2} bezüglich der ersten und zweiten Faserachse der Faser.

Andererseits ist es insbesondere für die Erzeugung einer scharfen, schmalen Beleuchtungslinie auch wünschenswert, dass der in die Lichtleitfaser eingekoppelte Lichtstrahl mit einer numerischen Apertur NA_{L} aus der Lichtleitfaser wieder austritt, die einen bestimmten Maximalwert NAₘₐₓ nicht überschreitet.

Wird ein Lichtstrahl zur Einkopplung in eine Lichtleitfaser fokussiert, so hängen die Parameter L_{L1} und NA_{L1} bezüglich der ersten Strahlachse des fokussierten Lichtstrahls bei bzw. kurz vor der Einkopplung in die Lichtleitfaser jeweils von der Länge der ersten Strahlachse L'_{L1} im Strahlprofil des zu fokussierenden Lichtstrahls und der Beugungsmaßzahl M_{L1}² bezüglich der ersten Strahlachse des zu fokussierenden Lichtstrahls vor dessen Fokussierung sowie von der Brennweite f der Fokussierung ab, d.h. L_{L1}=L_{L1}(L'_{L1},f,M_{L1}²) und NA_{L1}=NA_{L1}(L'_{L1},f,M_{L1}²). Analog dazu hängen die Parameter L_{L2} und NA_{L2} bezüglich der zweiten Strahlachse des fokussierten Lichtstrahls bei bzw. kurz vor der Einkopplung in die Lichtleitfaser jeweils von der Länge der zweiten Strahlachse L'_{L2} im Strahlprofil des zu fokussierenden Lichtstrahls und der Beugungsmaßzahl M_{L2}² bezüglich der zweiten Strahlachse des zu fokussierenden Lichtstrahls vor dessen Fokussierung sowie von der Brennweite f der Fokussierung ab, d.h. L_{L2}=L_{L2}(L'_{L2},f,M_{L2}²) und NA_{L2}=NA_{L2}(L'₁₂,f,M_{L2}²).

Die optische Einkopplungseinrichtung umfasst vorzugsweise eine Kollimations- und Aufweitungsoptik. Die Kollimations- und Aufweitungsoptik ist insbesondere dazu eingerichtet, einen Lichtstrahl in einen umgeformten Lichtstrahl derart umzuformen, dass der umgeformte Lichtstrahl kollimiert ist. Die Kollimations- und Aufweitungsoptik kann dazu eingerichtet sein, den Lichtstrahl in den umgeformten Lichtstrahl derart umzuformen, dass der umgeformte Lichtstrahl ein Strahlprofil aufweist, in dem die Länge einer ersten Strahlachse einer vorgegebenen ersten Länge L'_{L1} und die Länge einer zweiten Strahlachse einer vorgegebenen zweiten Länge L'_{L2} entspricht. Die Kollimations- und Aufweitungsoptik kann insbesondere dazu eingerichtet sein, den Lichtstrahl in den umgeformten Lichtstrahl derart umzuformen, dass der umgeformte Lichtstrahl ein Strahlprofil aufweist, in dem die Länge L'_{L1} der ersten Strahlachse im Verhältnis zur Länge L'_{L2} der zweiten Strahlachse einem vorgegebenen Aspektverhältnis Y_{L} = L'_{L1}:L'_{L2} entspricht, wobei insbesondere das Aspektverhältnis Y_{L}=L'_{L1}:L'_{L2} im Strahlprofil des umgeformten Lichtstrahls im Wesentlichen dem Aspektverhältnis Y_{F}=L_{F1}:L_{F2} im Querschnitt einer Lichtleitfaser entspricht, Y_{L}∼Y_{F} . Die Kollimations- und Aufweitungsoptik kann insbesondere dazu eingerichtet sein, den Lichtstrahl in den umgeformten Lichtstrahl derart umzuformen, dass die Länge L'_{L1} oder L'_{L2} bezüglich lediglich einer der beiden ersten und zweiten Strahlachsen im Strahlprofil des umgeordneten Lichtstrahls im Vergleich zur Länge bezüglich der entsprechenden Strahlachse im Strahlprofil des umzuformenden Lichtstrahls verändert (also aufgeweitet oder gestaucht) ist. Die Kollimations- und Aufweitungsoptik ermöglicht es somit, einen kollimierten Lichtstrahl mit einstellbaren Längen L'L1 und L'_{L2} und damit auch einstellbarem Aspektverhältnis Y_{L} bereitzustellen. Daraus ergibt sich eine Möglichkeit, die Parameter L_{L1}=L_{L1}(L'_{L1},f,M_{L1}²), NA_{L1}= NA_{L1}(L'_{L1},f,M_{L1}²) und SPP_{L1}=SPP_{L1}(L_{L1},NA_{L1}) relativ zu den Parametern L_{L2}=L_{L2}(L'_{L2},f,M_{L2}²), NA_{L2}=NA_{L2}(L'_{L2},f,M_{L2}²) bzw. SPP_{L2}=SPP_{L2}(L_{L2},NA_{L}) des Lichtstrahls kurz vor bzw. bei Eintritt in eine Lichtleitfaser derart zu verändern, dass eine an die Geometrie und die Strahlparameterprodukte SPP_{F1} und SPP_{F2} der Lichtleitfaser angepasste Einkopplung des Lichtstrahls möglich ist.

Die optische Einkopplungseinrichtung umfasst vorzugsweise mindestens einen im Strahlengang eines Lichtstrahls angeordneten Strahlteiler, der dazu eingerichtet ist, den Lichtstrahl geometrisch in mindestens einen ersten und einen zweiten Teillichtstrahl derart aufzuteilen, dass das Verhältnis aus der Beugungsmaßzahl M_{L1}² bezüglich der ersten Strahlachse des ersten Teillichtstrahls und der Beugungsmaßzahl M_{L2}² bezüglich der zweiten Strahlachse des ersten Teillichtstrahls an ein vorgegebenes Verhältnis T=M_{L1}²:M_{L2}² angepasst ist, wobei insbesondere der Faktor T ungefähr 0,5 oder ungefähr 2 beträgt, also T~0,5 oder T~2. Der Strahlteiler kann insbesondere dazu eingerichtet sein, den Lichtstrahl derart aufzuteilen, dass die Beugungsmaßzahl M_{L1}² oder M_{L2}² bezüglich lediglich einer der beiden ersten und zweiten Strahlachsen im Strahlprofil des ersten Teillichtstrahls im Vergleich zur Beugungsmaßzahl bezüglich der entsprechenden Strahlachse im Strahlprofil des zu teilenden Lichtstrahls verändert (also vergrößert oder verkleinert) ist. Der Strahlteiler ermöglicht es somit, die Beugungsmaßzahl M_{L1}² relativ zur Beugungsmaßzahl M_{L2}² des (Teil-) Lichtstrahls vor dessen Fokussierung auf die Lichtleitfaser einzustellen. Daraus ergibt sich eine weitere Möglichkeit, die Parameter L_{L1}=L_{L1}(L'_{L1},f,M_{L1}²)_{,} NA_{L1}=NA_{L1}(L'_{L1},f,M_{L1}²) und SPP_{L1}=SPP_{L1}(L_{L1},NA_{L1}) relativ zu den Parametern L_{L2}=L_{L2}(L'_{L2},f,M_{L2}²), NA_{L2}=NA_{L2}(L'_{L2},f,M_{L2}²) bzw. SPP_{L2}=SPP_{L2}(L_{L2},NA_{L2}) des Lichtstrahls kurz vor bzw. bei Eintritt in eine Lichtleitfaser derart zu verändern, dass eine an die Geometrie und die Strahlparameterprodukte SPP_{F1} und SPP_{F2} der Lichtleitfaser angepasste Einkopplung des Lichtstrahls möglich ist.

Mit Bezug auf den zweiten Teillichtstrahl kann der Strahlteiler auch dazu eingerichtet sein, den Lichtstrahl geometrisch in mindestens den ersten und den zweiten Teillichtstrahl derart aufzuteilen, dass das Verhältnis aus der Beugungsmaßzahl M_{L1}² bezüglich der ersten Strahlachse des zweiten Teillichtstrahls und der Beugungsmaßzahl M_{L2}² bezüglich der zweiten Strahlachse des zweiten Teillichtstrahls an ein vorgegebenes Verhältnis T'=M_{L1}²:M_{L2}² angepasst ist, wobei insbesondere T'∼T oder T'=T gelten kann. Der Strahlteiler kann insbesondere dazu eingerichtet sein, den Lichtstrahl geometrisch in mindestens den ersten und den zweiten Teillichtstrahl derart aufzuteilen, dass die Beugungsmaßzahl M_{L1}² oder M_{L2}² bezüglich lediglich einer der beiden ersten und zweiten Strahlachsen im Strahlprofil des zweiten Teillichtstrahls im Vergleich zur Beugungsmaßzahl bezüglich der entsprechenden Strahlachse im Strahlprofil des zu teilenden Lichtstrahls verändert (also vergrößert oder verkleinert) ist.

Der Strahlteiler kann mindestens eine Spiegelfläche aufweisen. Die Spiegelfläche kann eine scharfe, insbesondere geradlinige Spiegelflächenkante aufweisen. Die Spiegelflächenkante kann parallel entweder zur ersten oder zur zweiten Strahlachse des zu teilenden Lichtstrahls verlaufen. Die Spiegelfläche kann derart im Strahlengang des zu teilenden Lichtstrahls angeordnet sein, dass durch Reflexion ein Teil des Lichtstrahls aus dem Strahlengang des Lichtstrahls abgezweigt wird, wobei der von der Spiegelfläche reflektierte Teil des Lichtstrahls den ersten Teillichtstrahl bildet und der von der Spiegelfläche nicht reflektierte Teil des Lichtstrahls den zweiten Teillichtstrahl bildet. Die Spiegelfläche kann insbesondere im Strahlengang des zu teilenden Lichtstrahls derart angeordnet sein, dass die Spiegelfläche von einer Richtung her entlang einer der beiden ersten und zweiten Strahlenachsen des Lichtstrahls nur derart weit in den Lichtstrahl hineinragt, dass die Spiegelfläche lediglich einen Teil der ersten bzw. zweiten Strahlachse des Lichtstrahls abdeckt, dessen Länge im Vergleich zur gesamten Länge der ersten bzw. zweiten Strahlachse des Lichtstrahls um den Faktor T kürzer ist. Der Strahlteiler kann auch mehrere im Strahlengang versetzt zueinander angeordnete Spiegelflächen umfassen.

Der Strahlteiler kann im Strahlengang eines kollimierten Lichtstrahls hinter einer Kollimations- und Aufweitungsoptik angeordnet sein. Der Strahlteiler kann im Strahlengang eines kollimierten Lichtstrahls hinter einer Kollimations- und Aufweitungsoptik zur Aufteilung des kollimierten Lichtstrahls in Teillichtstrahlen insbesondere derart angeordnet sein, dass die Strahlachse eines Teillichtstrahls, bezüglich derer sich die Beugungsmaßzahl M₁² oder M₂² verändert, derjenigen Strahlachse des kollimierten Lichtstrahls entspricht, bezüglich derer die Länge L_{L1} oder L_{L2} verändert. Der Strahlteiler kann dazu eingerichtet sein, den kollimierten Lichtstrahl geometrisch in mindestens einen ersten und einen zweiten kollimierten Teillichtstrahl aufzuteilen.

Die optische Einkopplungseinrichtung umfasst vorzugsweise eine Einkoppeloptik zum Fokussieren eines Lichtstrahls in eine Lichtleitfaser. Die Einkoppeloptik kann im Strahlengang hinter dem Strahlteiler zur Fokussierung von Teillichtstrahlen in Lichtleitfasern angeordnet sein. Die optische Einkopplungseinrichtung kann für jede Lichtleitfaser eine Einkoppeloptik umfassen. Die Einkoppeloptik kann als sphärische, insbesondere als korrigierte asphärische Linse mit einer Brennweite f ausgebildet sein. Die Einkoppeloptik kann eine numerische Apertur NA_{EO} auf mit NA_{EO}>NA_{max,1,} NA_{EO}>NA_{max,2} und/oder NA_{EO}≥0,2 aufweisen.

Somit ergibt sich für die optische Einkopplungseinrichtung folgendes: Anhand der Ausgestaltung der Kollimations- und Aufweitungsoptik ist es möglich, für jeden Teillichtstrahl die Parameter L'_{L1} und L'_{L2} im Strahlprofil des zu fokussierenden Teillichtstrahls unabhängig voneinander einzustellen. Anhand der Ausgestaltung des Strahlteilers ist es möglich, für jeden Teillichtstrahl die Parameter M_{L1}² und M_{L2}² des zu fokussierenden Teillichtstrahls unabhängig voneinander einzustellen. Schließlich ist es anhand der Ausgestaltung der Einkoppeloptik möglich, den Parameter f einzustellen. Damit lassen sich auch die Parameter L_{L1}=L_{L1}(L'_{L1},f,M_{L1}²), NA_{L1}=NA_{L1}(L'_{L1},f,M_{L1}²), L_{L2}=L_{L2}(L'_{L2},f,M_{L2}²) und NA_{L2}=NA_{L2}(L'_{L2},f,M_{L2}²) des auf die Lichtleitfaser fokussierten Teillichtstrahls unabhängig voneinander einstellen.

Demnach erlaubt es die optische Einkopplungseinrichtung anhand der Ausgestaltung der Kombination aus Kollimations- und Aufweitungsoptik, Strahlteilers und Einkoppeloptik, die Parameter L_{L1}=L_{L1}(L'_{L1},f,M_{L1}²), NA_{L1}=NA_{L1}(L'_{L1},f,M_{L1}²), L_{L2}=L_{L2}(L'_{L2},f,M_{L2}²) und NA_{L2}=NA_{L2}(L'_{L2},f,M_{L2}²) der Teillichtstrahlen gezielt an die Parameter L_{F1}, L_{F2} und NA_{F} der Lichtleitfaser und/oder gewünschte vorgegebene Parameter NA_{max,1} und NA_{max,2} anzupassen.

Insbesondere kann die Kombination aus Kollimations- und Aufweitungsoptik, der Strahlteiler und die Einkoppeloptik dazu eingerichtet sein, die Teillichtstrahlen in die Lichtleitfasern derart einzukoppeln, dass die Länge L_{L1} der ersten Strahlachse im Strahlprofil eines Teillichtstrahls an die Länge L_{F1} der ersten Faserachse im Querschnitt einer Lichtleitfaser und Länge L_{L2} der zweiten Strahlachse im Strahlprofil des Teillichtstrahls an die Länge L_{F2} der zweiten Faserachse der Lichtleitfaser bei Eintritt des Teillichtstrahl in die Lichtleitfaser angepasst sind, wobei insbesondere L_{L1}=ηxL_{F1} und L_{L1}=ηxL_{F1} mit einem vorgegebenen Wert 0≤n≤1, z.B. η=60-70%. Dies erlaubt es, dass die Einkopplung eines (Teil-) Lichtstrahls in eine Lichtleitfaser ohne Überstrahlung des Querschnitts der Lichtleitfaser erfolgen kann. Damit kann die Geometrie des Strahlprofils des Lichtstrahls in die Geometrie des Querschnitts der Lichtleitfaser verlässlich eingepasst werden, woraus sich ein effizientes und verlustarmes Einkoppeln des Lichtstrahls in die Lichtleitfaser ergibt.

Zusätzlich oder alternativ kann die Kombination aus Kollimations- und Aufweitungsoptik, der Strahlteiler und die Einkoppeloptik dazu eingerichtet sein, die Teillichtstrahlen in die Lichtleitfasern derart einzukoppeln, dass die numerischen Apertur NA_{L1} bezüglich der ersten Strahlachse eines Teillichtstrahls der numerischen Apertur NA_{F} einer Lichtleitfaser oder einem vorgegeben ersten Maximalwert NA_{max,1} entspricht und die numerische Apertur NA_{L2} bezüglich der zweiten Strahlachse des Teillichtstrahls der numerischen Apertur NA_{F} der Lichtleitfaser oder einem vorgegeben zweiten Maximalwert NA_{max,2} entspricht, wobei insbesondere NA_{max,1}~NAmax,₂ oder Na_{max,1}∼N2xNA_{max,2}. Zum Beispiel ist NA_{max,1}=0,12. Dies erlaubt es, die Geometrie des Eintrittskegels eines (Teil-) Lichtstrahls bei Eintritt in eine Lichtleitfaser an die Geometrie des Eintrittskegels der Lichtleitfaser anzupassen. Daraus ergibt sich ebenfalls ein effizientes und verlustarmes Einkoppeln des Lichtstrahls in die Lichtleitfaser. Zusätzlich oder alternativ ist es auch möglich, die numerische Apertur NA_{L} des Lichtstrahls bei Wiederaustritt aus der Lichtleitfaser einzustellen.

Die optische Einkopplungseinrichtung und die Lichtleitfasern sind vorzugsweise zueinander derart angeordnet, dass für jede Lichtleitfaser die erste Strahlachse des in die Lichtleitfaser einzukoppelnden Lichtstrahls parallel zur ersten Faserachse der Lichtleitfaser und die zweite Strahlachse des in die Lichtleitfaser einzukoppelnden Lichtstrahls parallel zur zweiten Faserachse der Lichtleitfaser orientiert sind.

Für jede Lichtquelle kann eine separate optische Einkopplungseinrichtung vorgesehen sein.

Die Lichtleitfasern können zueinander derart angeordnet sein, dass Propagationsrichtungen der aus den Lichtleitfasern austretenden Lichtstrahlen parallel zueinander orientiert sind und die Zentren der Strahltaillen der aus den Lichtleitfasern austretenden Lichtstrahlen innerhalb einer Ebene liegen. Daraus ergibt sich eine linienartige Anordnung der Faserenden und eine Anpassung der Gesamtgeometrie der aus den Lichtleitfasern austretenden Lichtstrahlen an die linienartige Geometrie der Beleuchtungslinie. Somit beginnt bereits bei Austritt der Lichtstrahlen aus den Lichtleitfasern eine auf die Formung einer Beleuchtungslinie angepasste Lichtverarbeitung.

Insbesondere können die Lichtleitfasern zueinander derart angeordnet sein, dass Propagationsrichtungen der aus den Lichtleitfasern austretenden Lichtstrahlen parallel zueinander orientiert sind, die ersten Faserachsen der Lichtleitfasern parallel zueinander orientiert sind und/oder die zweiten Faserachsen der Lichtleitfasern parallel zueinander orientiert sind. Dies hat insbesondere für Lichtleitfasern mit rechteckförmigem Querschnitt den Vorteil, dass die Querschnitte der so angeordneten Lichtleitfasern eine Gesamtgeometrie bilden, die an die Geometrie der Beleuchtungslinie angepasst ist.

Die optische Abbildungseinrichtung kann eine anamorphotische Optik umfassen. Die anamorphotische Optik ist gekennzeichnet durch eine erste Abbildungsachse und eine zur ersten Abbildungsachse senkrechte zweite Abbildungsachse und hat bezüglich der ersten und der zweiten Abbildungsachse unterschiedliche Abbildungseigenschaften. Die anamorphotische Optik ist ferner gekennzeichnet durch eine zur ersten und zur zweiten Abbildungsachse senkrechte optische Achse.

Die anamorphotische Optik ist dazu eingerichtet, die aus den Lichtleitfasern austretenden Lichtstrahlen bezüglich der ersten Faserachse auf die kurze Achse der Beleuchtungslinie zu fokussieren und bezüglich der zweiten Faserachse in der Beleuchtungslinie homogenisiert zu überlagern.

Die anamorphotische Optik und die Lichtleitfasern sind vorzugsweise zueinander derart angeordnet, dass für jede Lichtleitfaser die erste Faserachse der Lichtleitfaser parallel zur ersten Abbildungsachse und die zweite Faserachse der Lichtleitfaser parallel zur zweiten Abbildungsachse orientiert sind. Dies ist insbesondere für Lichtleitfasern mit rechteckförmigem Querschnitt vorteilhaft, da die Vorzugsachsen der Lichtleitfasern an die Vorzugsachsen der optischen Abbildungseinrichtung angepasst sind.

Insbesondere können die anamorphotische Optik und die Lichtleitfasern zueinander derart angeordnet sein, dass die Zentren der Strahltaillen der aus den Lichtleitfasern austretenden Lichtstrahlen entlang einer in einer Ebene liegenden gebogenen Referenzlinie derart positioniert sind, dass für jede Lichtleitfaser der aus dieser Lichtleitfaser austretende Lichtstrahl unabhängig vom Abstand des Zentrums der Stahltaille von der optischen Achse der anamorphotischen Optik auf die (eine!) Beleuchtungsebene fokussiert wird. Mit anderen Worten: Das Licht einer jeden Lichtleitfaser kann unabhängig von deren Abstand der Lichtleitfaser zur optischen Achse der anamorphotischen Optik auf eine (Einzel-) Beleuchtungslinie innerhalb der Beleuchtungsebene fokussiert werden. Dies ermöglicht es, dass alle Einzelbeleuchtungslinien scharf auf die Beleuchtungsebene abgebildet werden und somit die Einzelbeleuchtungslinien innerhalb der Beleuchtungsebene scharf zur (Gesamt-) Beleuchtungslinie überlagert werden können.

Zum Beispiel können die anamorphotische Optik und die Lichtleitfasern zueinander derart angeordnet sein, dass die (bezüglich der optischen Achse der anamorphotischen Optik) axialen Positionen der Zentren der Strahltaillen sich mit größer werdenden (bezüglich der optischen Achse der anamorphotischen Optik) radialen Abständen der Zentren der Strahltaillen in (bezüglich der optischen Achse der anamorphotischen Optik) axialer Richtung zur anamorphotischen Optik hin verlagert sind. Diese Anordnung der Lichtleitfasern erlaubt es beispielsweise, die Zentren der Strahltaillen derart anzuordnen, dass die optischen Wege, welche die aus den verschieden Lichtleitfasern austretenden Lichtstrahlen bis zu den Einzelbeleuchtungslinien durchlaufen, gleich lang sind.

Es ist ferner zweckmäßig, dass das optische System Justagemittel umfasst, die dazu eingerichtet sind, die Lichtleitfasern derart räumlich justierbar zu lagern, dass zumindest die Abstände der Zentren der Strahltaillen der aus den Lichtleitfasern austretenden Lichtstrahlen relativ zur anamorphotische Optik unabhängig voneinander einstellbar sind. Dies erlaubt es, die aus Licht der einzelnen Lichtleitfasern gebildeten Einzelbeleuchtungslinien relativ zur Beleuchtungsebene in Stahlrichtung zu verschieben und somit eine besonders scharfe (Gesamt-) Beleuchtungslinie zu erhalten.

Insbesondere kann die anamorphotische Optik dazu eingerichtet sein, die Länge L_{F1} der ersten Faserachse einer Lichtleitfaser mit einem Abbildungsmaßstab A auf die Länge L_{B1} der kurzen Achse der Beleuchtungslinie abzubilden. Insbesondere gilt: A= NA_{L}/NA_{AO,1}, wobei NA_{L} die numerische Apertur des aus der Lichtleitfaser austretenden Lichtstrahls und NA_{AO,1} die bildseitige numerische Apertur der anamorphotischen Optik bezüglich der ersten Abbildungsachse ist. Beispielsweise ist NA_{AO,1}∼0,25. Für NA_{L} gilt z.B. NA_{L∼}0,12, so dass insbesondere gilt: A∼1/2, d.h. die Länge L_{B1} der kurzen Achse der Beleuchtungslinie ist kürzer als die Länge L_{F1} der ersten Faserachse der Lichtleitfaser.

Wie bereits weiter oben erläutert, entspricht (beispielsweise bei Rechteckfasern) NA_{L} der größeren der beiden numerischen Aperturen NA_{L1} und NA_{L2} bzw. NA_{max,1} und NA_{max,2}, anhand derer der Lichtstrahl in die Lichtleitfaser eingekoppelt wird. Damit ergibt sich aus der Kombination der Lichtleitfasern mit der optischen Einkopplungseinrichtung und der optischen Abbildungseinrichtung folgender Vorteil: Da anhand der optischen Einkopplungseinrichtung die numerischen Aperturen NA_{L1} und NA_{L2} gezielt kleiner als ein Maximalwert NAₘₐₓ=max[NA_{max,1}, NA_{max,2}] gehalten werden können, können die aus den Lichtleitfasern wiederaustretenden Lichtstrahlen entsprechend eine numerische Apertur NA_{L} aufweisen, die ebenfalls kleiner als der Maximalwert NAₘₐₓ ist. Somit kann man bereits auf der Eingangsseite der Lichtleitfasern den Abbildungsmaßstab A=NA_{L}/NA_{AO,1} beeinflussen: Je kleiner NAₘₐₓ fasereingangseitig eingestellt wird, desto schmaler kann faserausgangsseitig die Beleuchtungslinie erzeugt werden.

Die anamorphotische Optik kann eine erste Kollimationszylinderlinse zur Kollimation der aus den Lichtleitfasern bezüglich der ersten Faserachse austretenden Lichtstrahlen und eine zweite Kollimationszylinderlinse zur Kollimation der aus den Lichtleitfasern bezüglich der zweiten Faserachse austretenden Lichtstrahlen umfassen. Damit ist es möglich, die Längen der Strahlachsen im Strahlprofil der kollimierten Lichtstrahlen bezüglich der ersten und der zweiten Faserachse unabhängig voneinander einzustellen.

Die anamorphotische Optik kann eine im Strahlengang hinter der ersten Kollimationszylinderlinse angeordnete Zylinderlinse zur Fokussierung der Lichtstrahlen bezüglich der ersten Faserachse auf ein erstes Zwischenbild und eine im Strahlengang hinter dem ersten Zwischenbild angeordnete weitere Zylinderlinse zur Fokussierung der Lichtstrahlen bezüglich der ersten Faserachse auf ein zweites Zwischenbild umfassen. Die Erzeugung zweier Zwischenbilder gewährleistet einen gewissen Einstellspielraum bei der Positionierung (der Faserenden) der Lichtleitfasern und der Überlagerung der Einzelbeleuchtungslinien zur Gesamtbeleuchtungslinie auf der Beleuchtungsebene.

Die anamorphotische Optik kann eine im Strahlengang hinter dem zweiten Zwischenbild angeordnete Fokussierungszylinderoptik zur Fokussierung der Lichtstrahlen bezüglich der ersten Faserachse auf die Beleuchtungslinie umfassen.

Die anamorphotische Optik kann eine anamorphotische Homogenisierungsoptik umfassen. Anamorphotische Homogenisierungsoptik ist insbesondere dazu eingerichtet, die aus den Lichtleitfasern bezüglich der zweiten Faserachse austretenden Lichtstrahlen zu homogenisieren. Die anamorphotische Homogenisierungsoptik kann zwei parallel zueinander angeordnete Zylinderlinsenarrays umfassen. Die anamorphotische Optik kann außerdem eine im Strahlengang den Zylinderlinsenarrays nachgeschaltete Kondensorzylinderlinse umfassen. Die Kondensorzylinderlinse ist insbesondere dazu eingerichtet, die anhand der anamorphotischen Homogenisierungsoptik homogenisierten Laserstrahlen auf die Beleuchtungslinie zu lenken und bezüglich der langen Achse der Beleuchtungslinie dort zu überlagern. Anhand der Kombination aus anamorphotischer Homogenisierungsoptik und Kondensorzylinderlinse lässt sich somit aus den Einzelbeleuchtungslinien die Beleuchtungslinie formen.

Insbesondere kann die Kondensorzylinderlinse dazu eingerichtet sein, die homogenisierten Lichtstrahlen telezentrisch auf die Beleuchtungslinie zu lenken. Telezentrisch bedeutet, dass die Hauptstrahlen der durch die Kondensorzylinderlinse umgelenkten Lichtstrahlen parallel zueinander verlaufen. Dies ermöglicht es, eine Bildfeldkrümmung der Einzelbeleuchtungslinien zu vermeiden.

Insbesondere ist die Zylinderlinse zur Fokussierung der Lichtstrahlen bezüglich der ersten Faserachse auf das erste Zwischenbild im Strahlengang vor der anamorphotische Homogenisierungsoptik und die Kondensorzylinderlinse im Strahlengang hinter dem ersten Zwischenbild angeordnet.

Alternativ zur Anordnung der Faseraustrittsflächen entlang einer gebogenen Referenzlinie, d.h. alternativ zur Anordnung der anamorphotischen Optik und der Lichtleitfasern zueinander derart, dass die Zentren der Strahltaillen der aus den Lichtleitfasern austretenden Lichtstrahlen entlang einer in einer Ebene liegenden gebogenen Referenzlinie derart positioniert sind, dass für jede Lichtleitfaser der aus dieser Lichtleitfaser austretende Lichtstrahl unabhängig vom Abstand des Zentrums der Stahltaille von der optischen Achse der anamorphotischen Optik auf die (eine!) Beleuchtungsebene fokussiert wird, kann insbesondere zur Erzeugung einer Zwischenabbildung bezüglich der ersten (z. B. kurzen, der ersten bzw. kurzen Faserachse entsprechenden) Strahlachse eine Zylinderlinsenteleskopanordnung vorgesehen sein. Insbesondere können die Zylinderlinsenteleskopanordnung und die Fokussierzylinderoptik derart angeordnet und/oder dazu eingerichtet sein, den Strahlquerschnitt bezüglich der ersten (also z. B. kurzen) Strahlachse derart anzupassen (z. B. zu vergrößern), dass die Beleuchtungslinie in der Beleuchtungsebene entlang ihrer kurzen Achse eine bestimmte (also gewünschte) Linienbreite aufweist.

Die Zylinderlinsenteleskopanordnung kann im Strahlengang der anamorphotischen Optik zwischen der ersten und zweiten Kollimationszylinderlinse einerseits und der anamorphotischen Homogenisierungsoptik anderseits angeordnet sein. Des Weiteren kann die Zylinderlinsenteleskopanordnung im Strahlengang der anamorphotischen Optik zwischen einer Transformationsanordnung (wie weiter unten beschrieben) einerseits und der anamorphotischen Homogenisierungsoptik anderseits angeordnet sein.

Die Zylinderlinsenteleskopanordnung umfasst zum Beispiel eine segmentierte Zylinderlinse und eine nicht-segmentierte Zylinderlinse. Die segmentierte Zylinderlinse kann mehrere Zylinderlinsensegmente umfassen, wobei insbesondere jeder Lichtleitfaser ein Zylinderlinsensegment zugeordnet ist. Dies ermöglicht eine Segmentierung des Strahlengangs innerhalb der anamorphotischen Optik.

Ein einzelnes Zylinderlinsensegment kann seinerseits als eine Zylinderlinse ausgesättet sein. Die Größe der Zylinderlinsensegmente (bezüglich der nicht-brechenden Achse des Zylinderlinsensegments) entspricht zum Beispiel der Länge der zweiten (also z. B. langen) Strahlachse des aus einer Lichtleitfaser austretenden und anhand der zweiten Kollimationszylinderlinse kollimierten Lichtstrahls (ggf. nach einer Strahltransformation mit einer weiter unten beschriebenen Transformationsoptik). Jedes Zylinderlinsensegment weist insbesondere eine brechende und eine nicht-brechende Achse auf. Hierzu weist das Zylinderlinsensegment beispielsweise bezüglich der ersten Strahlachse eine endliche Brennweite auf, bezüglich der zweiten Strahlachse weist jedes Zylinderlinsensegment keine (bzw. eine unendliche) Brennweite auf. Dadurch wird der aus der Lichtleitfaser austretende Lichtstrahl bezüglich der zweiten Strahlachse optisch nicht verarbeitet (d.h. nicht gebrochen oder umgelenkt). Hingegen wird der aus der Lichtleitfaser bezüglich der ersten (z. B. kurzen) Faserachse austretende und anhand der ersten Kollimationszylinderlinse kollimierte Lichtstrahl mit der Zylinderlinsenteleskopanordnung optisch verarbeitet. Dabei kann das Zylinderlinsensegment den bezüglich der ersten (also z. B. kurzen) Faserachse austretendein und anhand der ersten Kollimationszylinderlinse kollimierten Lichtstrahl bezüglich der ersten Strahlachse auf die Zwischenabbildung fokussieren. Die Brennweiten der Zylinderlinsensegmente bezüglich der ersten Strahlachse können identisch sein. Mit der nicht-segmentierten Zylinderlinse der Zylinderlinsenteleskopanordnung wird der von der Zwischenabbildung ausgehende Lichtstrahl wieder kollimiert. Daher kann die Zylinderlinsenteleskopanordnung als ein Bündel mehrerer, parallel angeordneter, bezüglich der ersten Faserachse/Strahlachse wirkender Beam-Expander angesehen werden.

Die einzelnen Zylinderlinsensegmente der segmentierten Zylinderlinse können durch entsprechende Justagemittel der Zylinderlinsenteleskopanordnung in Strahl richtung (d.h. entlang der optischen Achse der anamorphotischen Optik) unabhängig voneinander justierbar ausgestaltet sein. Dies erlaubt es, unabhängig von dem Abstand der Lichtleitfasern zur optischen Achse der anamorphotischen Optik die durch die aus den einzelnen Lichtleitfasern austretenden Lichtstrahlen gebildeten Beleuchtungslinien in derselben Beleuchtungsebene zu einer scharfen Beleuchtungslinie zu überlagern, auch wenn die Lichtleitfasern entlang einer (ungebogenen) Geraden angeordnet sind. Dies hat den Vorteil, dass die Faserenden der Lichtleitfasern in einer Ebene (und nicht auf einer gebogenen Referenzlinie) angeordnet werden können. Damit kann die Anordnung der Lichtleitfasern einfach gestaltet und die Überlagerung der einzelnen Beleuchtungslinien durch das Justagemittel der Zylinderlinsenteleskopanordnung bewerkstelligt werden.

Die anamorphotische Optik kann ferner eine Interferenzunterdrückungseinrichtung umfassen. Die Interferenzunterdrückungseinrichtung ist derart ausgebildet und im Strahlengang der anamorphotischen Optik derart angeordnet, dass an optische Komponenten, die der Interferenzunterdrückungseinrichtung im Strahlengang der anamorphotischen Optik nachgeschaltet sind, also zum Beispiel an den Zylinderlinsen der Zylinderlinsenarrays der anamorphotischen Homogenisierungsoptik durch Gitterbeugung des aus einer (einzelnen) Lichtleitfaser austretenden kohärenten Lichts resultierende Interferenzphänomene unterdrückt oder vermieden werden. Dies ermöglicht eine homogene Beleuchtungslinie ohne oder stark reduzierte Intensitätsmodulationen.

Die Interferenzunterdrückungseinrichtung kann im Strahlengang der anamorphotischen Optik zwischen den Kollimationszylinderlinsen einerseits und der anamorphotischen Homogenisierungsoptik andererseits und/oder zwischen der Zylinderlinsenteleskopanordnung einerseits und der anamorphotischen Homogenisierungsoptik andererseits angeordnet sein.

Die Interferenzunterdrückungseinrichtung kann mehrere Glasblöcke umfassen. Die Glasböcke können quaderförmig bzw. als Säulen mit rechteckigem Querschnitt stabförmig ausgestaltet sein.

Mehrere Glasblöcke können zu einem Glasblock-Array zusammengefasst sein. Insbesondere können für jedes Zylinderlinsensegment der segmentierten Zylinderlinse der Zylinderlinsenteleskopanordnung mehrere Glasblöcke vorgesehen sein, die zu einem Glasblock-Array zusammengefasst sind.

Die Glasblöcke, insbesondere die Glasblöcke eines Glasblock-Arrays können untereinander unterschiedliche geometrische Längen aufweisen zur Erzeugung von optischen Laufwegunterschieden für die sich zur Beleuchtungslinie überlagernden Lichtbündeln. Insbesondere können die Laufwegunterschiede größer oder annähernd so groß wie die Kohärenzlänge (d.h. die zeitliche Kohärenz bzw. die Länge eines Wellenzuges) des durch die anamorphotische Optik zu verarbeitenden Lichts sein.

Der optische Laufweg eines Lichtstrahls innerhalb eines Mediums ergibt sich aus dem Produkt der vom Lichtstrahl durchlaufenen geometrischen (Weg-) Länge multipliziert mit dem Brechungsindex n des Mediums. Luft hat zum Beispiel einen Brechungsindex von n∼1. Die Glasblöcke haben beispielsweise einen Brechungsindex von n=1,46 (für eine Wellenlänge von 532 nm). Hierzu können die Glasblöcke aus einem synthetischen Glas gefertigt sein. Im Vergleich zu Luft verzögern die Glasböcke also hindurchtretendes Licht. Ein Beispiel: Bei einer vom Lichtstrahl mit der Wellenlänge 532 nm durchlaufenen geometrischen (Weg-) Länge von 100 mm beträgt der relative (Vergleich Luft - Glasblock) Laufwegunterschied (1,46 - 1) x 100 mm = 46 mm, was durch Umrechnung anhand der Lichtgeschwindigkeit einer zeitlichen Verzögerung von etwa 0,15 ns entspricht. Beträgt die Kohärenzlänge des Lichtes nun weniger als 46 mm, treffen sich in der Beleuchtungsebene gegeneinander verzögerte Wellenzüge mit fester Phasenbeziehung nicht mehr, so dass es zu konstruktiver/destruktiver Interferenz nicht mehr kommen kann. Dies gewährleistet eine homogene Intensitätsverteilung innerhalb der Beleuchtungslinie.

In der hinsichtlich der optischen Achse der anamorphotischen Optik lateralen Richtung kann ein Glasblock denselben Querschnitt aufweisen wie eine diesem Glasblock im Strahlengang nachgeschaltete Zylinderlinse eines Zylinderlinsenarrays der anamorphotischen Homogenisierungsoptik.

Zudem kann die Interferenzunterdrückungseinrichtung für jeden Glasblock eine dem Glasblock im Strahlengang vorgeschaltete Zylinderlinse aufweisen, die dazu eingerichtet ist, Licht in den Glasblock, insbesondere ins Zentrum des Glasblocks zu fokussieren. Dadurch kann zum Beispiel das aus einer Lichtleitfaser austretende und durch die Kollimationszylinderlinse köllimierte Licht nach einem etwaigen Durchlaufen einer Zylinderlinsenteleskopanordnung von einer Zylinderlinse der Interferenzunterdrückungseinrichtung fokussiert werden, und zwar innerhalb des nachgeschalteten Glasblocks. Insbesondere ist die Brennweite der Zylinderlinse der Interferenzunterdrückungseinrichtung derart angepasst, dass der fokussierte Lichtstrahl den nachgeschalteten Glasblock entlang der (gesamten) geometrischen Länge des Glasblocks durchläuft, ohne dabei seitlich aus dem Glasblock auszutreten. Dies erlaubt eine verlustfreie Homogenisierung der Beleuchtungslinie.

Die Brennweite der Zylinderlinsen der Interferenzunterdrückungseinrichtung ist beispielsweise einheitlich und insbesondere so gewählt, dass sie größer ist als die Kohärenzlänge des zu verarbeitenden Lichts und/oder größer ist als etwa ein halb mal der geometrischen Länge des Glasblocks, der unter den Glasblöcken (insbesondere unter den Glasblöcken eines Glasblockarrays) die längste geometrische Länge aufweist. Eine typische Brennweite einer Zylinderlinse der Interferenzunterdrückungseinrichtung beträgt zum Beispiel etwa 80 mm. Die Breite der Zylinderlinse bezüglich der zweiten (also z.B. langen) Strahlachse/Faserachse kann der Breite einer.Zylinderlinse der anamorphotischen Homogenisierungsoptik bezüglich derselben Achse entsprechen.

Die Glasblöcke eines ersten Teils der in einem Glasblock-Array angeordneten Glasblöcke können untereinander jeweils verschiedene geometrische Längen aufweisen. Ebenso können die Glasblöcke eines zweiten Teils der in dem Glasblock-Array angeordneten Glasblöcke untereinander jeweils verschiedene geometrische Längen aufweisen. Dabei kann insbesondere die geometrische Länge eines jeden Glasblocks im ersten Teil des Glasblock-Arrays länger sein als die geometrische Länge eines jeden Glasblocks im zweiten Teil des Glasblock-Arrays. Ferner können die Glasblöcke im Glasblock-Array derart angeordnet, dass in direkter Nachbarschaft zu jedem Glasblock des ersten Teils ein Glasblock des zweiten Teils, nicht jedoch ein anderer Glasblock des ersten Teils angeordnet ist. Mit anderen Worten: Bilden die Glasblöcke eines Glasblock-Arrays einen Stapel, so sind in diesem Stapel Glasblöcke des ersten Teils im Wechsel mit Glasblöcken des zweiten Teils angeordnet. Somit können die Laufwegunterschiede von aus direkt benachbarten Glasblöcken austretenden kohärenten Lichtstrahlen besonders gut verzögert werden. Dadurch können Interferenzphänomene besonders wirksam unterdrückt werden.

Die Interferenzunterdrückungseinrichtung kann ferner im Strahlengang den Glasblöcken nachgeschaltete weitere Zylinderlinsen aufweisen, wobei jedem Glasblock bzw. jeder dem Glasblock vorgeschalteten Zylinderlinse eine weitere Zylinderlinse zugeordnet ist. Jede Zylinderlinse der Interferenzunterdrückungseinrichtung und die ihr zugeordnete weitere Zylinderlinse,der Interferenzunterdrückungseinrichtung können in Teleskopanordnung derart angeordnet sein, dass in die Zylinderlinse eintretendes kollimiertes Licht nach zwischenzeitlicher Fokussierung im Glasblock nach Austritt aus der weiteren Zylinderlinse wieder kollimiert (also re-kollimiert) ist. Die re-kollimierten Lichtstrahlen können besonders einfach zu der einen Beleuchtungslinie überlagert werden.

Alternativ hierzu kann in der Interferenzunterdrückungseinrichtung aber auch gezielt auf die weiteren Zylinderlinsen zur Re-kollimation verzichtet werden. In diesem Fall sind die den Glasblöcken im Strahlengang vorgeschalteten Zylinderlinsen und die Glasblöcke derart angeordnet und ausgebildet, dass die in die Glasböcke bezüglich der zweiten (also z.B. langen) Strahlachse fokussierten Lichtstrahlen bei Wiederaustritt aus den Glasblöcken Lichtkegel hinsichtlich der zweiten Strahlachse bilden, welche jeweils mehrere Zylinderlinsen des Zylinderlinsenarrays der anamorphotischen Homogenisierungsoptik bestrahlen. Hierdurch wird jede Zylinderlinse des Zylinderlinsenarrays der anamorphotischen Homogenisierungsoptik mit Licht, das durch mehrere benachbarte Glasblöcke parallel hindurchgetreten ist, ausgeleuchtet. Dies führt zu einer verbesserten Homogenisierung der Beleuchtungslinie

Durch die vorangehende Ausgestaltung der Interferenzunterdrückungseinrichtung ohne weitere Zylinderlinsen treffen jedoch (unter Umständen) kohärente Strahlenteile auf benachbarte Zylinderlinsen des Zylinderlinsenarrays der anamorphotischen Homogenisierungsoptik. Dies kann zu den genannten Interferenzphänomenen führen.

Zur Vermeidung oder Unterdrückung von Interferenzphänomenen kann das dem im Strahlengang dem ersten Zylinderlinsenarray der anamorphotische Homogenisierungsoptik nachgeschaltete zweite Zylinderlinsenarray der anamorphotische Homogenisierungsoptik abwechselnd aus dicken Zylinderlinsen und dünnen Zylinderlinsen aufgebaut (insbesondere gestapelt) sein. Hierbei können die dicken Zylinderlinsen derart ausgebildet sein, dass deren abbildende Eigenschaften, Brennweiten und Hauptebenen denen der dünnen Zylinderlinsen entsprechen. Insbesondere können die dicken Zylinderlinsen derart ausgebildet sein, dass sie dieselben optischen Abbildungseigenschaften wie die dünnen Zylinderlinsen aufweisen, jedoch in Vergleich zu diesen einen Laufwegunterschied in der Größenordnung der Kohärenzlänge des zu verarbeitenden Lichts bewirken. Zum Beispiel kann beim Einsatz von dünnen Zylinderlinsen mit einem (Krümmungs-) Radius von 10 mm und mit einer Linsendicke von 3 mm eine dicke Zylinderlinse in Form einer bikonvexen Linse mit einem (Krümmungs-) Radius von 20 mm und einer Linsendicke von 40 mm annähernd dieselben Abbildungseigenschaften in der anamorphotischen Homogenisierungsoptik erfüllen, dabei jedoch im Vergleich zu den dünnen Zylinderlinsen einen Laufwegunterschied von etwa 20 mm bei einem Brechungsindex von 1,5 erzeugen. Die so erzeugten Laufwegunterschiede tragen dann zur Unterdrückung der konstruktiven/destruktiven Interferenz in der Beleuchtungsebene bei. Somit wird eine gute Homogenisierung der Beleuchtungslinie ermöglicht.

In dem optischen System kann eine Transformationsoptik verwendet werden. Die Transformationsoptik ist insbesondere dazu eingerichtet, einen in die Transformationsoptik eintretenden Lichtstrahl derart umzuordnen, dass das Strahlparameterprodukt bezüglich einer ersten Strahlachse im Strahlprofil des umzuordnenden Lichtstrahls nach der Umordnung um einen Faktor U verkleinert ist. Der Faktor U kann 2 oder mehr betragen. Die Umformung kann ferner die Wirkung haben, dass das Strahlparameterprodukt bezüglich einer zur ersten Strahlachse senkrechten zweiten Strahlachse im Strahlprofil des umzuordnenden Lichtstrahls nach der Umordnung vergrößert wird. Anhand der durch die Transformationsoptik bewirkte Umordnung ist es möglich, für eine vorgegebene maximale numerische Apertur NA_{AO} zur Erzeugung der Beleuchtungslinie die Länge L_{B1} der kurzen Achse der Beleuchtungslinie zu verkleinern und/oder die Tiefenschärfe der Beleuchtungslinie im Bereich der Beleuchtungsebene zu vergrößern.

Insbesondere kann die Transformationsoptik mehrere Teleskopanordnungen umfassen, die dazu eingerichtet sind, den durch die Transformationsoptik hindurchtretenden Lichtstrahl in mehrere Teillichtstrahlen zu segmentieren und die einzelnen Teillichtstrahlen derart umzuordnen, dass die Strahlprofile der Teillichtstrahlen nach der Umordnung jeweils um die Propagationsrichtung des jeweiligen Teillichtstrahls um einen Winkel 90° gedreht ist.

Die vorgenannten Eigenschaften der Transformationsoptik werden mit Hilfe eines bestimmten optischen Elements ermöglicht. Das optische Element ist durch Schneiden einer Zylinderlinse entlang mindestens zweier Schnittflächen erhältlich, die schräg stehen zur Zylindersymmetrieachse der Zylinderlinse. Die Zylindersymmetrieachse der Zylinderlinse entspricht der Symmetrieachse, welche sich aus der Zylindersymmetrie einer zylindermantelförmigen Zylinderfläche der Zylinderlinse ergibt. Aus der zylindermantelförmigen Zylinderfläche resultiert eine Brennweite f_{Z} der Zylinderlinse. Demnach ist das optische Element auch durch die Zylindersymmetrieachse und durch die Brennweite f_{Z} charakterisierbar. Der Begriff "schräg" ist in dem Sinne zu verstehen, dass die Schnittflächen und die Zylindersymmetrieachse der Zylinderlinse den Winkel β=45° einschließen.

Die Zylinderlinse aus der das optische Element erhältlich ist kann plan-konvex ausgebildet sein und eine ebene Grundfläche und gegenüberliegend die zylindermantelförmige Zylinderfläche aufweisen. Die Schnittflächen der optischen Elemente können eben/plan ausgebildet sein und parallel und/oder orthogonal zueinander verlaufen. Die Schnittflächen können senkrecht zur ebenen Grundfläche der Zylinderlinse orientiert sein. Somit kann ein optisches Element selbst eine ebene Grundfläche und gegenüberliegend eine gekrümmte Fläche aufweisen, wobei sich die gekrümmte Fläche an eine Zylindermantelfläche anschmiegen kann. Insbesondere können vier orthogonale Schnittflächen vorgesehen sein.

Die Transformationsoptik kann mehrere optische Elemente mit der gleichen Brennweite f_{Z} aufweisen. Insbesondere können zwei optische Elemente zu einer der oben erwähnten Teleskopanordnungen der Transformationsoptik kombiniert werden. In der Teleskopanordnung können die optischen Elemente im Strahlengang hintereinander im Abstand 2xf_{Z} angeordnet und die jeweiligen Zylindersymmetrieachsen der optischen Elemente parallel zueinander ausgerichtet sein. Dadurch ist die Teleskopanordnung als ein 1:1 Zylinderlinsenteleskop zu verstehen, das eine Drehung des Strahlprofils eines in die Teleskopanordnung eintretenden Lichtstrahls um den Winkel 180°-2xβ=90° ermöglicht, wobei die Drehachse der Richtung des Strahlengangs entspricht.

Die Transformationsoptik kann insbesondere mehrere solcher Teleskopanordnungen umfassen. Dabei können die im Strahlengang vorderen optischen Elemente der Teleskopanordnungen in einem ersten Array angeordnet sein und die im Strahlengang hinteren optischen Elemente der Teleskopanordnungen in einem zweiten Array angeordnet sein. Zum Beispiel sind innerhalb des ersten und zweiten Arrays die optischen Elemente mit deren ebenen Grundflächen jeweils in einer ersten bzw. zweiten Ebene angeordnet, wobei die Schnittflächen der optischen Elemente aneinander anliegen und die Zylindersymmetrieachsen der optischen Elemente parallel zueinander ausgerichtet sind. Jedes der Arrays kann somit als Stapel aus optischen Elementen verstanden werden.

Eine solche Transformationsoptik kann einen Teil einer optischen Abbildungseinrichtung bilden. Insbesondere kann die Transformationsoptik In der optischen Abbildungseinrichtung im Strahlengang hinter einer ersten Kollimationszylinderlinse zur Kollimation aus Lichtleitfasern bezüglich einer ersten Faserachse austretenden Lichtstrahlen, hinter einer zweite Kollimationszylinderlinse zur Kollimation der aus den Lichtleitfasern bezüglich einer zweiten Faserachse austretenden Lichtstrahlen und vor einer anamorphotischen Homogenisierungsoptik angeordnet sein.

Eine Anlage zur Bearbeitung von Dünnfilmschichten umfasst mindestens einen Laser zur Erzeugung eines Lichtstrahls, einen Träger, auf welchen eine Materialschicht aufbringbar oder aufgebracht ist, und ein oben beschriebenes optisches System und/oder eine oben beschriebene Transformationsoptik. Die Anlage ist dazu ausgebildet und angeordnet, die Materialschicht mit dem durch die Mehrzahl Lichtleitfasern des optischen Systems geleiteten und/oder durch die Transformationsoptik umgeordneten Lichtstrahl zu beaufschlagen, um die Materialschicht zumindest durch kurzzeitiges Aufschmelzen zu verarbeiten.

Das optische System kann auch als ein unabhängiges Modul ausgebildet sein, welches in eine Anlage zur Bearbeitung von Dünnschichtfilmschichten quasi als Aufrüstung (im Englischen: upgrade) nachträglich eingebracht werden kann. Insofern kann das optische System gegenüber einer solchen Anlage auch als separate Vorrichtung verstanden und beansprucht werden. Gleiches gilt für die einzelnen Komponenten des optischen Systems: Die optische Einkopplungseinrichtung, die Mehrzahl Lichtleitfasern, die optische Abbildungseinrichtung und die Transformationsoptik können jeweils auch als ein unabhängiges Sub-Modul ausgebildet sein, welches in das optische System und damit letztendlich auch in die Anlage zur Bearbeitung von Dünnschichtfilmschichten eingebracht werden kann. Insofern können die optische Einkopplungseinrichtung, die Mehrzahl Lichtleitfasern, die optische Abbildungseinrichtung und insbesondere auch die Transformationsoptik gegenüber einem solchen optischen System und gegenüber einer solchen Anlage zur Bearbeitung von Dünnschichtfilmschichten als separate Einrichtungen (Sub-Module) verstanden und beansprucht werden.

Sofern in dieser Anmeldung von Licht die Rede ist, kann darunter Laserlicht verstanden werden. Andererseits kann unter Laserlicht auch Licht im Allgemeinen verstanden werden. Sofern in dieser Anmeldung von Linse die Rede ist (z.B. Zylinderlinse, sphärische Linse, asphärische Linse usw.), kann darunter auch ein aus mehreren Einzelkomponenten zusammengesetztes Linsensystem verstanden werden. Im Rahmen dieser Anmeldung ist unter Strahlachse eine Strahlprofilachse zu verstehen, also eine das Strahlprofil charakterisierende gerade Achse innerhalb des Strahlprofils. Die geometrische Länge eines Glasblocks ist die von einem anhand des Glasblocks zu verarbeitenden (verzögernden) Lichtstrahls innerhalb des Glasblocks zu durchlaufende geometrische Länge. Die geometrische Länge kann auch Null sein.

Die Erfindung wird nachfolgend anhand der beigefügten Zeichnungen weiter erläutert, von denen
- Fig. 1: eine schematische Übersichtsdarstellung eines Ausführungsbeispiels einer Anlage zur Bearbeitung von Dünnfilmschichten zeigt,
- Fig. 2 und 3: schematische Darstellungen von Ausführungsbeispielen einer optischen Einkopplungseinrichtung zeigen,
- Fig. 4 bis 6: schematische Darstellungen von Ausführungsbeispielen einer optischen Abbildungsvorrichtung zeigen,
- Fig. 7: eine schematische Darstellung eines Ausführungsbeispiels einer anamorphotischen Homogenisierungsoptik zeigt,
- Fig. 8: eine schematische Darstellung eines Ausführungsbeispiels einer Teleskopanordnung zeigt,
- Fig. 9: eine schematische Darstellung eines Ausführungsbeispiels zur Herstellung eines optischen Elements zeigt,
- Fig. 10 bis 13: schematische Darstellungen von Ausführungsbeispielen einer optischen Abbildungsvorrichtung mit einer Transformationsoptik zeigen,
- Fig. 14: eine schematische Darstellung eines Ausführungsbeispiels einer optischen Abbildungsvorrichtung zeigt,
- Fig. 15: eine schematische Darstellung eines Ausführungsbeispiels einer Zylinderlinsenteleskopanordnung zeigt,
- Fig. 16: eine schematische Darstellung eines Ausführungsbeispiels einer optischen Abbildungsvorrichtung zeigt,
- Fig. 17: eine schematische Darstellung eines Ausführungsbeispiels einer Interferenzunterdrückungseinrichtung zeigt,
- Fig. 18a und 18b: weitere schematische Darstellungen des in Fig. 17 gezeigten Ausführungsbeispiels einer Interferenzunterdrückungseinrichtung zeigen,
- Fig. 19: eine schematische Darstellung eines Ausführungsbeispiels einer Interferenzunterdrückungseinrichtung zeigt,
- Fig. 20: eine weitere schematische Darstellung des in Fig. 19 gezeigten Ausführungsbeispiels einer Interferenzunterdrückungseinrichtung zeigt, und
- Fig. 21: eine schematische Darstellung eines Interferenzphänomens zeigt.

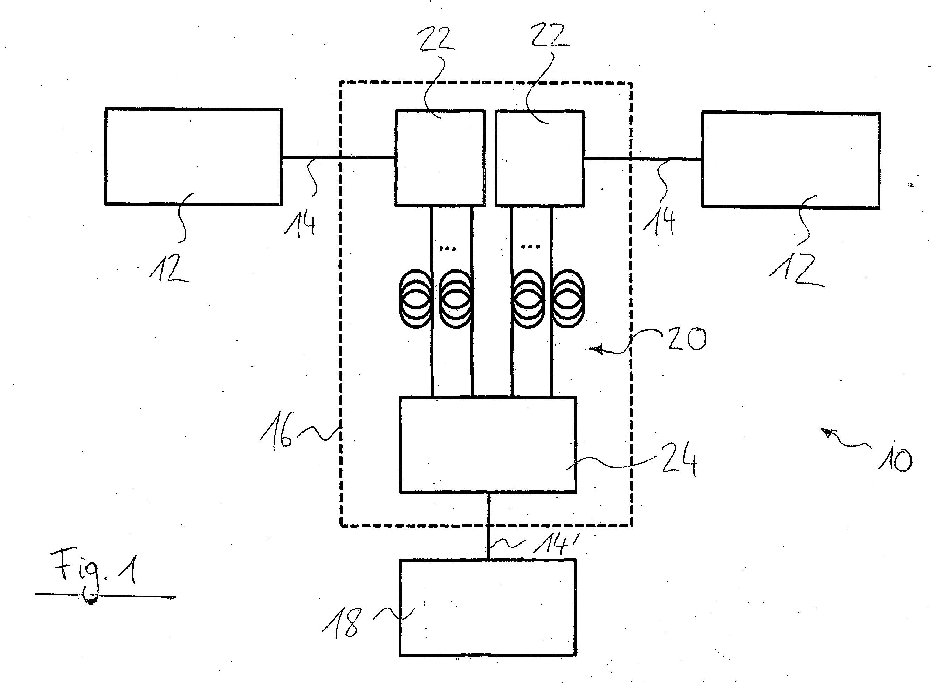

Eine Anlage zur Bearbeitung von Dünnfilmschichten ist in Fig. 1 allgemein mit 10 bezeichnet. Die Anlage 10 umfasst mindestens eine Lichtquelle 12 zur Erzeugung eines Lichtstrahls 14. Beispielsweise ist die Lichtquelle 12 als gepulster Festkörperlaser ausgebildet, der einen kohärenten Laserstrahl mit einer Zentralwelleniänge λ im Bereich von etwa 510 bis 540nm emittiert. Die Puls-Repititionsrate beträgt typischerweise 10 kHz.

Die Anlage 10 umfasst außerdem ein optisches System 16, welches den Lichtstrahl 14 der mindestens einen Lichtquelle 12 zu einem Lichtstrahl 14' verarbeitet und diesen auf einen Träger 18 lenkt, auf welchem eine Materialschicht aufgebracht ist. Bei der Materialschicht handelt es sich beispielsweise um eine etwa 50nm dicke a-SiSchicht, in welcher sich Elektronen mit einer relativ geringen Mobilität von etwa 0,5cm²/Vs bewegen können. Der verarbeitete Lichtstrahl 14' wird mit einer Geschwindigkeit von etwa 1 bis 2µm pro Puls (d.h. etwa 10 bis 20mm/s bei einer Repetitionsrate von 10 kHz) relativ zum Träger 18 über die Materialschicht bewegt. Hierbei ist die Intensität des gepulsten Lichtstrahls 14 derart eingestellt, dass die a-Si-Schicht auf einer Zeitskala von etwa 50 bis 100ns aufschmilzt und sich anschließend z.B. als kristalline p-Si-Schicht verfestigt, in welcher sich die Elektronen mit einer relativ hohen Mobilität von etwa 100cm²/Vs bewegen können.

Das optische System 16 umfasst drei Komponenten (Sub-Module): Zum einen sind mehrere Lichtleitfasern 20 zum Leiten des Laserlichts 14 vorgesehen. Die Anzahl N der Lichtleitfasern 20 ist also N≥2. Außerdem ist mindestens eine optische Einkopplungseinrichtung 22 zum Einkoppeln des Lichtstrahls 14 in mehrere Lichtleitfasern 20 vorhanden. Sind mehrere Lichtquellen 12 vorhanden, so ist für jede Lichtquelle 12 eine separate optische Einkopplungseinrichtung 22 und eine separate Mehrzahl an Lichtleitfasern 20 vorgesehen. Ferner weist das optische System 16 eine optische Abbildungseinrichtung 24 auf, die dazu eingerichtet ist, mit den aus den Lichtleitfasern 20 wieder austretenden Lichtstrahlen eine Beleuchtungslinie zu bilden, deren Form eine lange Achse und eine kurze Achse aufweist Die Beleuchtungslinie wird dabei in einer Beleuchtungsebene auf der Materialschicht abgebildet.

Die Lichtleitfasern 20 sind im Folgenden beispielsweise als Rechteckfasern ausgebildet, d.h. die Geometrie des Querschnitts der Lichtleitfasern 20 ist durch eine erste Faserachse der Länge L_{F1} und eine zur ersten Faserachse senkrechten zweite Faserachse der Länge L_{F2} gekennzeichnet, wobei die Länge L_{F1} im Verhältnis zur Länge L_{F2} ein von eins verschiedenes Aspektverhältnis ergibt: LF1:L_{F2}=Y_{F}:1=Y_{F}≠1. Die numerische Eingangs- und Ausgangs-Apertur NA_{F} der Lichtleitfasern 20 ist bezüglich beider Faserachsen gleich groß und beträgt im Folgenden beispielsweise NA_{F} ∼0,22.

Für eine effiziente Einkopplung eines Lichtstrahls 14 in die Lichtleitfasern 20 ist eine separate Anpassung des Lichtstrahls 14 bezüglich der ersten und der zweiten Faserachsen erforderlich.

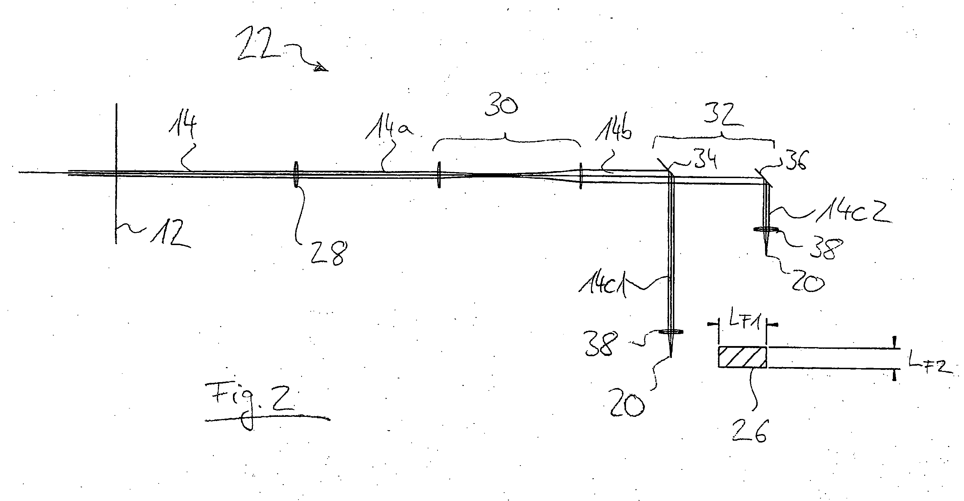

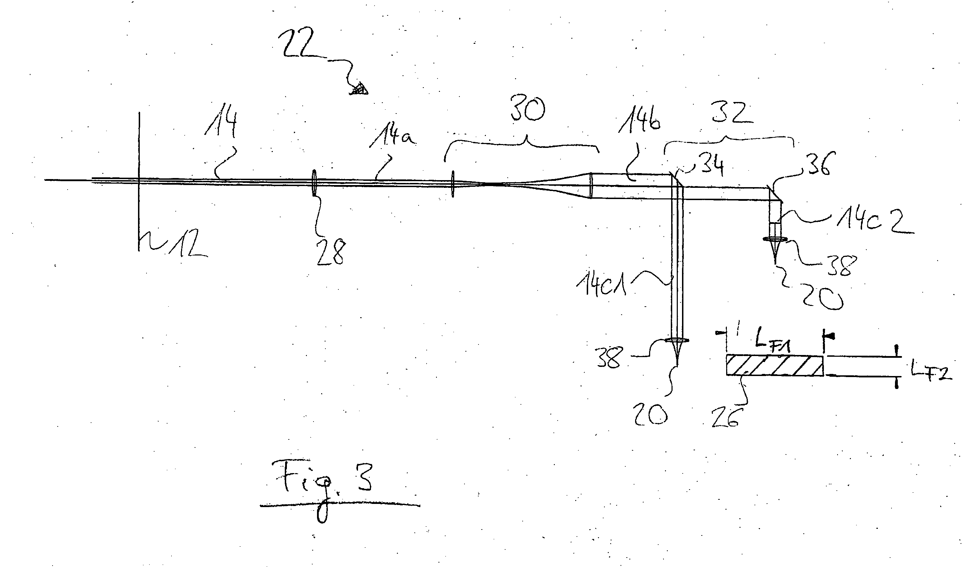

In Fig. 2 und 3 sind Ausführungsbeispiele der optischen Einkopplungseinrichtung 22 gezeigt, anhand derer eine solche Anpassung vorgenommen wird. In diesen Ausführungsbeispielen wird der Lichtstrahl 14 einer Lichtquelle 12 in zwei (d.h. N=2) Lichtleitfasern 20 eingekoppelt. In Fig. 2 weisen die Lichtleitfasern 20 beispielsweise einen rechteckförmigen Querschnitt 26 mit den Längen L_{F1}=150µm und L_{F2}=75µm und dem Aspektverhältnis Y_{F}=2 auf. In Fig. 3 weisen die Lichtleitfasern 20 beispielsweise einen rechteckförmigen Querschnitt 26 mit den Längen L_{F1}=300µm und L_{F2}=75µm und dem Aspektverhältnis Y_{F}=4 auf.

Zunächst wird der Lichtstrahl 14 mit einer beispielsweise als sphärische Linse ausgebildeten Kollimationsoptik 28 der optischen Einkopplungseinrichtung 22 derart kollimiert, dass der Lichtstrahl 14a rotationssymmetrisch bezüglich seiner Propagationsrichtung ist. Das Strahlprofil des Lichtstrahls 14a ist im Wesentlichen kreisförmig, so dass die Länge L_{L1} einer ersten Strahlachse im Strahlprofil des Lichtstrahls 14a und die Länge L_{L2} einer zur ersten Strahlachse senkrechten zweiten Strahlachse im Strahlprofil des Lichtstrahls 14a im Wesentlichen gleich lang sind, also L_{L1}∼L_{L2} und Y_{L}=L_{L1}:L_{L2}∼1. Beispielsweise ist L_{L1}∼L_{L2}∼6mm. Ferner weist der Lichtstrahl 14a beispielsweise eine bezüglich der ersten und der zweiten Strahlachse gleich große Beugungsmaßzahl von M_{L1}²=M_{L2}²=M²∼5-30 auf.

Der so kollimierte Lichtstrahl 14a'wird dann anhand eines Zylinderlinsenteleskops 30 der optischen Einkopplungseinrichtung 22 entlang der (in Fig. 2 und 3 innerhalb der Zeichenebene orientierten) ersten Strahlachse des Strahlprofils aufgeweitet. Hierzu ist das Zylinderlinsenteleskop 30 dazu eingerichtet ist, den kollimierten Lichtstrahl 14a durch Veränderung der Länge lediglich der ersten Strahlachse im Strahlprofil des kollimierten Lichtstrahls 14a derart aufzuweiten, dass das Aspektverhältnis Y_{L}=L_{L1}:L_{L2} im Strahlprofil des aufgeweiteten Lichtstrahls 14b dem Aspektverhältnis Y_{F}=L_{F1}:L_{F2} der Lichtleitfaser 20 entspricht. Im Beispiel der Fig. 2 (Y_{F}=2) verlängert das Zylinderlinsenteleskop 30 die Länge L_{L1} der ersten Strahlachse im Strahlprofil des kollimierten Lichtstrahls 14a um den Faktor H=Y_{F}/Y_{L}=2, während die Länge L_{L2} der zweiten Strahlachse im Strahlprofil des kollimierten Lichtstrahls 14a unverändert bleibt. Im Beispiel der Fig. 3 (Y_{F}=4) verlängert das Zylinderlinsenteleskop, 30 die Länge L_{L1} der ersten Strahlachse im Strahlprofil des kollimierten Lichtstrahls 14a um den Faktor Y_{F}/Y_{L}=4, während die Länge L_{L2} der zweiten Strahlachse im Strahlprofil des kollimierten Lichtstrahls 14a unverändert bleibt.

Im Strahlengang zwischen der Kollimationsoptik 28 und dem Zylinderlinsenteleskop 30 kann bei Bedarf zusätzlich ein Beam-Expander angeordnet sein, der dazu eingerichtet ist, die Längen bezüglich beider Strahlachsen im Strahlprofil des kollimierten Lichtstrahls 14a um denselben Faktor auf einen gewünschten Wert einzustellen.

Die Kollimationsoptik 28, das Zylinderlinsenteleskop 30 und ggf. der Beam-Expander repräsentieren eine Kollimations- und Aufweitungsoptik, die dazu geeignet ist, den Lichtstrahl 14 in den umgeformten Lichtstrahl 14b derart umzuformen, dass der umgeformte Lichtstrahl 14b ein Strahlprofil aufweist, in dem die Länge der ersten Strahlachse gemäß einer vorgegebenen ersten Länge L'_{L1} und die Länge der zweiten Strahlachse gemäß einer vorgegebenen zweiten Länge L'_{L2} und/oder das Aspektverhältnis Y_{L} = L'_{L1}:L'_{L2} gemäß einem vorgegebenen Aspektverhältnis beliebig eingestellt werden kann/können.

Anschließend wird der so umgeformte, insbesondere aufgeweitete Lichtstrahl 14b von einem Strahlteiler 32 der optischen Einkopplungseinrichtung 22 geometrisch in zwei Teillichtstrahlen 14c1 und 14c2 aufgeteilt. Der Strahlteiler umfasst zwei im Strahlengang des aufgeweiteten Lichtstrahls 14b versetzt zueinander angeordnete Spiegelflächen 34 und 36.

Die erste Spiegelfläche 34 weist eine scharfe geradlinige Spiegelflächenkante auf. Die Spiegelfläche 34 zweigt durch Reflexion einen Teil des Lichtstrahls 14b aus dem Strahlengang des Lichtstrahls 14b ab. Der von der Spiegelfläche 34 reflektierte Teil des Lichtstrahls 14b bildet den ersten Teillichtstrahl 14c1. Der von der Spiegelfläche 34 nicht reflektierte Teil des Lichtstrahls 14b bildet den zweiten Teillichtstrahl 14c2. Die zweite Spiegelfläche 36 lenkt den zweiten Teillichtstrahl 14c2 lediglich um.

Die Spiegelfläche 34 ist im Strahlengang des aufgeweiteten Lichtstrahls 14b derart angeordnet, dass der Lichtstrahl 14b geometrisch derart aufgeteilt wird, dass die Beugungsmaßzahl M_{L1}² lediglich entlang der (in Fig. 2 und 3 parallel zur Zeichenebene orientierten) ersten Strahlachse des ersten Teillichtstrahls 14c1 im Vergleich zur Beugungsmaßzahl M_{L1}² entlang der ersten Strahlachse des ungeteilten Lichtstrahls 14b um einen Faktor T=0,5 verkleinert, also halbiert ist. Die Beugungsmaßzahl M_{L2}² entlang der (in Fig. 2 und 3 senkrecht zur Zeichenebene orientierten) zweiten Strahlachse des ersten Teillichtstrahls 14c1 bleibt jedoch im Vergleich zur Beugungsmaßzahl M_{L2}² entlang der zweiten Strahlachse des ungeteilten Lichtstrahls 14b unverändert.

Analoges gilt für den zweiten Teillichtstrahl 14c2: Die Beugungsmaßzahl M_{L1}² ist ebenfalls lediglich entlang der (in Fig. 2 und 3 parallel zur Zeichenebene orientierten) ersten Strahlachse des zweiten Teillichtstrahls 14c2 im Vergleich zur Beugungsmaßzahl M_{L1}² entlang der ersten Strahlachse des ungeteilten Lichtstrahls 14b um einen Faktor T=0,5 verkleinert, also halbiert. Die Beugüngsmaßzahl M_{L2}² entlang der (in Fig. 2 und 3 senkrecht zur Zeichenebene orientierten) zweiten Strahlachse des zweiten Teillichtstrahls 14c2 bleibt jedoch im Vergleich zur Beugungsmaßzahl M_{L2}² entlang der zweiten Strahlachse des ungeteilten Lichtstrahls 14b unverändert.

Hierzu ist die Spiegelfläche 34 im Strahlengang des zu teilenden Lichtstrahls 14b derart angeordnet, dass die Spiegelfläche 34 von einer Richtung her entlang einer der beiden ersten und zweiten Strahlenachsen des Lichtstrahls 14b nur derart weit in den Lichtstrahl 14b hineinragt, dass die Spiegelfläche 34 lediglich einen Teil der ersten bzw. zweiten Strahlachse des Lichtstrahls 14b abdeckt, dessen Länge im Vergleich zur gesamten Länge der ersten bzw. zweiten Strahlachse des zu teilenden Lichtstrahls 14b um den Faktor T kürzer ist.

Für jede Lichtleitfaser 20 ist eine als korrigierte asphärische Linse ausgebildete Einkoppeloptik 38 der optischen Einkopplungseinrichtung 22 mit einer numerischen Apertur NA_{EO}>0,2 mit einer Brennweite f vorgesehen. Die Einkoppeloptik 38 ist dazu eingerichtet, die Teillichtstrahlen 14c1 und 14c2 jeweils in eine Lichtleitfaser 20 zu fokussieren. Die Brennweite f der Einkoppeloptik 38 ist im Beispiel der Fig. 2 f=25mm und im Beispiel der Fig. 3 f=50mm.

Der Strahldurchmesser des kollimierten, rotationssymmetrischen Lichtstrahls 14a und die Parameter H, T und f sind so gewählt, dass die optische Einkopplungseinrichtung 22 die Teillichtstrahlen 14c1, 14c2 in die Lichtleitfasern 20 derart einkoppelt, dass die Länge L_{L1} der ersten Strahlachse der Teillichtstrahlen 14c1, 14c2 an die Länge L_{F1} der ersten Faserachse der Lichtleitfasern 20 und die Länge L_{L2} der zweiten Strahlachse der Teillichtstrahlen 14c1, 14c2 an die Länge L_{F2} der zweiten Faserachse der Lichtleitfasern 20 bei Eintritt der Teillichtstrahlen 14c1, 14c2 in die Lichtleitfasern 20 derart angepasst ist, dass L_{L1}=ηxL_{F1} und L_{L2}=ηxL_{F2} mit einem vorgegebenen Wert von η∼60-70%.

Außerdem sind der Strahldurchmesser des kollimierten, rotationssymmetrischen Lichtstrahls 14a und die Parameter H, T und f so gewählt, dass die optische Einkopplungseinrichtung 22 die Teillichtstrahlen 14c1, 14c2 in die Lichtleitfasern 20 derart einkoppelt, dass die numerische Apertur NA_{L1} bezüglich der ersten Strahlachse der Teillichtstrahlen 14c1, 14c2 einem vorgegebenen ersten Maximalwert NA_{max,1} und die numerische Apertur NA_{L2} bezüglich der zweiten Strahlachse der Teillichtstrahlen 14c1, 14c2 einem vorgegeben zweiten Maximalwert NA_{max,2} entspricht. Im Beispiel der Fig. 2 ist NA_{max,1}=NA_{max,2}=0,12. Im Beispiel der Fig. 3 ist NA_{max,1}=2xNA_{max,2}=0,12.

Es sei noch angemerkt, dass die optische Einkopplungseinrichtung 22 und die Lichtleitfasern 20 zueinander derart angeordnet sind, dass für jede Lichtleitfaser 20 die erste Strahlachse des in die Lichtleitfaser 20 einzukoppelnden Lichtstrahls 14c1, 14c2 parallel zur ersten Faserachse der Lichtleitfaser 20 und die zweite Strahlachse des in die Lichtleitfaser 20 einzukoppelnden Lichtstrahls 14c1, 14c2 parallel zur zweiten Faserachse der Lichtleitfaser 20 orientiert sind.

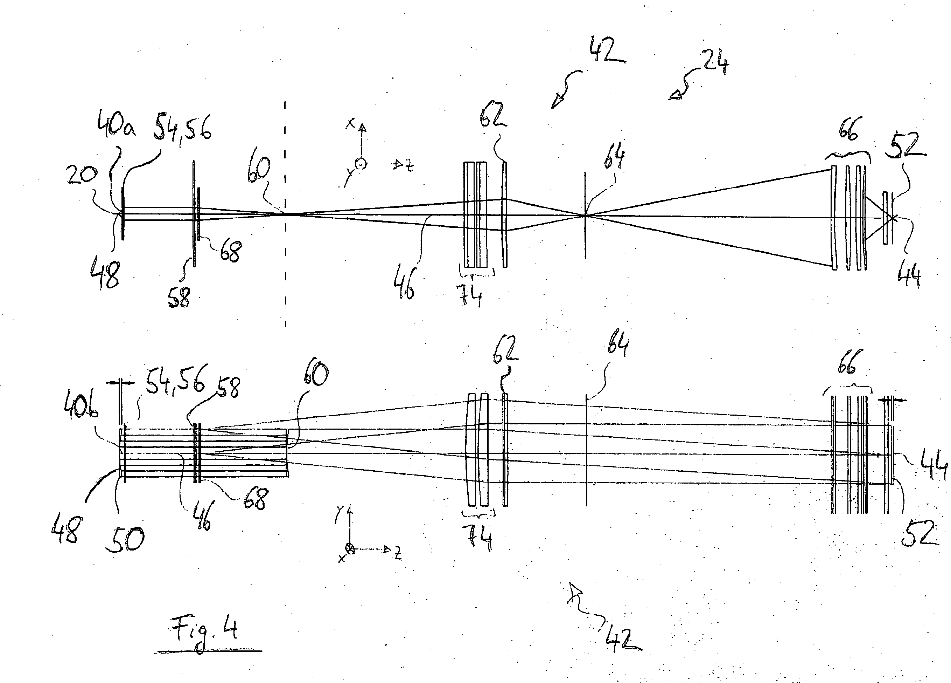

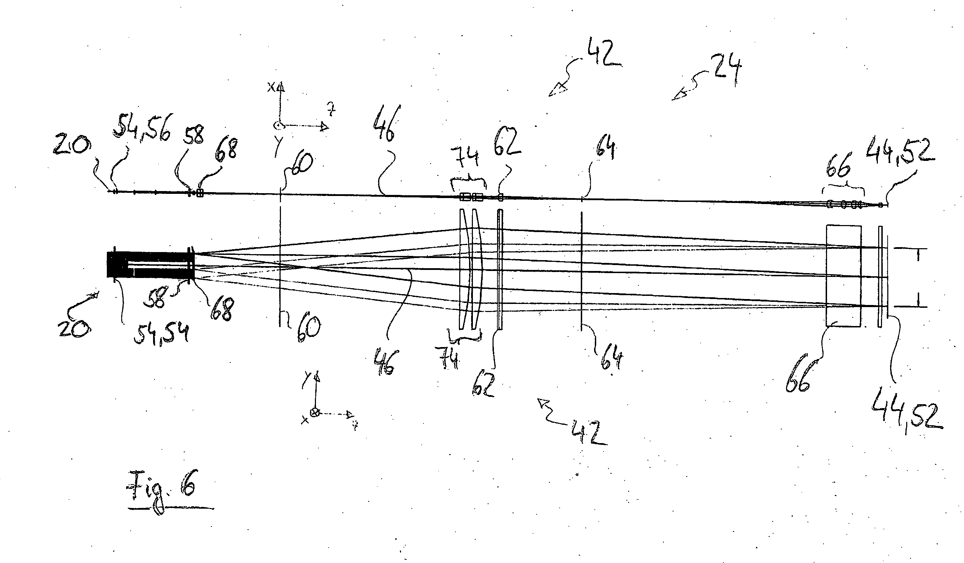

In Fig. 4, 5 und 6 sind Ausführungsbeispiele der optischen Abbildungsvorrichtung 24 gezeigt, die das Licht nach Wiederaustritt aus den Lichtleitfasern 20 weiter verarbeitet.

Die optischen Abbildungsvorrichtung 24 umfasst eine anamorphotische Optik 42, die genkennzeichnet ist durch eine (zur x-Achse des Koordinatensystems im oberen Bildteil von Fig. 4, 5 und 6 parallele) erste Abbildungsachse x, eine (zur y-Achse des Koordinatensystems im unteren Bildteil von Fig. 4, 5 und 6 parallele) zur ersten Abbildungsachse x senkrechte zweite Abbildungsachse y und eine zur ersten und zur zweiten Abbildungsachse x, y senkrechten (zur z-Achse der Koordinatensysteme in Fig. 4, 5 und 6 parallele) optische Achse 46. Die anamorphotische Optik 42 hat bezüglich der ersten und der zweiten Abbildungsachse x, y unterschiedliche Abbildungseigenschaften. Die anamorphotische Optik 42 und die Lichtleitfasern 20 sind zueinander derart angeordnet, dass für jede Lichtleitfaser 20 die erste Faserachse parallel zur ersten Abbildungsachse x und die zweite Faserachse parallel zur zweiten Abbildungsachse y orientiert sind. Insofern kann als Bezugszeichen für die erste. Faserachse x und für die zweite Faserachse y verwendet werden.

Die anamorphotische Optik 42 ist dazu eingerichtet, die aus den Lichtleitfasern 20 bezüglich der ersten Faserachse x austretenden Lichtstrahlen 40a auf die kurze Achse der Beleuchtungslinie 44 zu fokussieren (siehe jeweils den oberen Bildteil von Fig. 4, 5 und 6) und die aus den Lichtleitfasern 20 bezüglich der zweiten Faserachse y austretenden Lichtstrahlen 40b in der Beleuchtungslinie 44 homogenisiert zu überlagern (siehe jeweils den unteren Bildteil von Fig. 4, 5 und 6).

Die Lichtleitfasern 20 (genauer: deren Faserenden) sind zueinander derart angeordnet, dass Propagationsrichtungen der aus den Lichtleitfasern 20 austretenden Lichtstrahlen 40a, 40b parallel zueinander orientiert sind, die ersten Faserachsen x der Lichtleitfasern 20 parallel zueinander orientiert sind und die zweiten Faserachsen y der Lichtleitfasern 20 parallel zueinander orientiert sind. Außerdem liegen die zweiten Faserachsen y der Lichtleitfasern 20 innerhalb einer zur zweiten Abbildungsachse y und zur optischen Achse 46 parallelen y-z-Ebene. Die rechteckförmigen Querschnitte 26 der Lichtleitfasern 20 sind demnach parallel zur Beleuchtungsebene 52 orientiert. Die Gesamtgeometrie der aus den Lichtleitfasern 20 austretenden Lichtstrahlen 40a, 40b ist damit an die Geometrie der Beleuchtungslinie 44 angepasst, was die weitere Verarbeitung der Lichtstrahlen 40a, 40b wesentlich vereinfacht.

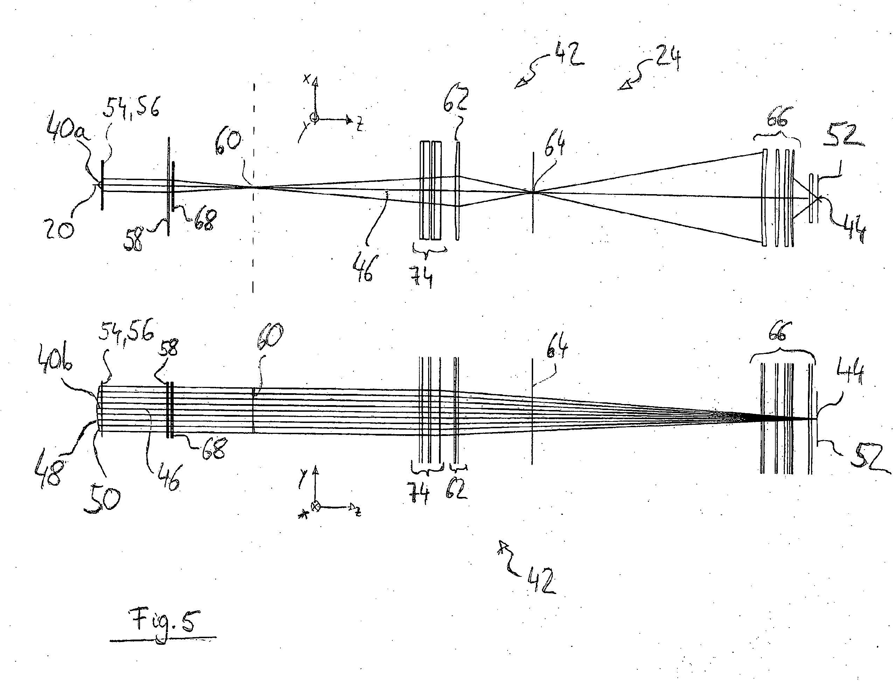

Jeweils in den unteren Bildteilen von Fig. 4 und 5 ist gezeigt, dass darüber hinaus die Lichtleitfasern 20 zueinander derart angeordnet sind, dass die Zentren 48 der Strahltaillen der aus den Lichtleitfasern 20 austretenden Lichtstrahlen 40a, 40b entlang einer in der y-z-Ebene liegenden gebogenen Referenzlinie 50 derart positioniert sind, dass die bezüglich der optischen Achse 46, die parallel zu den Propagationsrichtungen der aus den Lichtleitfasern 20 austretenden Lichtstrahlen 40a, 40b und durch den Schwerpunkt der Referenzlinie 50 verläuft, axialen Positionen der Zentren 48 sich mit größer werdenden radialen Abständen der Zentren 48 von der optischen Achse 46 in der axialen z-Richtung hin parallel zur optischen Achse 46 verlagert sind. Diese Anordnung der Lichtleitfasern 20 erlaubt es beispielsweise, Zentren 48 der Strahltaillen derart anzuordnen, dass die optischen Wege, welche die aus den verschieden Lichtleitfasern 20 austretenden Lichtstrahlen 40a, 40b bis zu den Einzelbeleuchtungslinien 44 durchlaufen, gleich lang sind.

Insgesamt sind die anamorphotische Optik 42 und die Lichtleitfasern 20 zueinander derart angeordnet, dass die Zentren 48 der Strahltaillen entlang der gebogenen Referenzlinie 50 derart positioniert sind, dass für jede Lichtleitfaser 20 der aus dieser Lichtleitfaser 20 austretende Lichtstrahl 40a, 40b unabhängig vom Abstand des Zentrums 48 der Strahltaille von der optischen Achse 46 auf genau eine Beleuchtungsebene 52 fokussiert wird. Mit anderen Worten: Die Lichtstrahlen 40b einer jeden Lichtleitfaser 20 werden unabhängig vom Abstand der Lichtleitfaser 20 zur optischen Achse 46 auf die Beleuchtungslinie 44 innerhalb der Beleuchtungsebene 52 fokussiert. Dies ermöglicht es, die Lichtstrahlen 40a, 40b zu einer scharfen (Gesamt-) Beleuchtungslinie 44 zu überlagern.

Für eine axiale Positionierung der Zentren 48 ist es zweckmäßig, dass das optische System 16 Justagemittel (nicht dargestellt) umfasst, die dazu eingerichtet sind, die Lichtleitfasern 20 unabhängig voneinander derart räumlich justierbar zu lagern, dass zumindest die (bezüglich der optischen Achse 46) axialen Abstände der Zentren 48 relativ zur anamorphotische Optik 42 positionierbar sind. Dies erlaubt es, die aus den einzelnen Lichtstrahlen 40b der einzelnen Lichtleitfasern 20 gebildeten Einzelbeleuchtungslinien bezüglich der Beleuchtungsebene 52 in Stahlrichtung z wie gewünscht zu verschieben und somit eine besonders scharfe (Gesamt-) Beleuchtungslinie 44 zu erzeugen.

Die anamorphotische Optik 42 umfasst eine erste Kollimationszylinderlinse 54 zur Kollimation der aus den Lichtleitfasern 20 bezüglich der ersten Faserachse x austretenden Lichtstrahlen 40a und eine zweite Kollimationszylinderlinse 56 zur Kollimation der aus den Lichtleitfasern 20 bezüglich der zweiten Faserachse y austretenden Lichtstrahlen 40b.

Die anamorphotische Optik 42 umfasst ferner eine im Strahlengang hinter der ersten Kollimationszylinderlinse 54 angeordnete Zylinderlinse 58 zur Fokussierung der Lichtstrahlen 40a bezüglich der ersten Faserachse x auf ein erstes Zwischenbild 60 und eine im Strahlengang hinter dem ersten Zwischenbild 60 angeordnete weitere Zylinderlinse 62 zur nochmaligen Fokussierung der Lichtstrahlen 40a bezüglich der ersten Faserachse x auf ein zweites Zwischenbild 64. Die Erzeugung zweier Zwischenbilder 60, 64 gewährleistet einen gewissen Einstellspielraum bei der axialen Positionierung der Zentren 48.

Schließlich weist die anamorphotische Optik 42 noch eine im Strahlengang hinter dem zweiten Zwischenbild 64 angeordnete Fokussierungszylinderoptik 66 zur Fokussierung der Lichtstrahlen 40a bezüglich der ersten Faserachse x auf die Beleuchtungslinie 44 auf.

Zudem ist in der anamorphotischen Optik 42 eine im Strahlengang hinter der Zylinderlinse 58 und vor dem ersten Zwischenbild 60 angeordnete anamorphotische Homogenisierungsoptik 68 vorgesehen, welche dazu eingerichtet ist, die aus den Lichtleitfasern 20 bezüglich der zweiten Faserachse y austretenden Lichtstrahlen 40b zu homogenisieren.

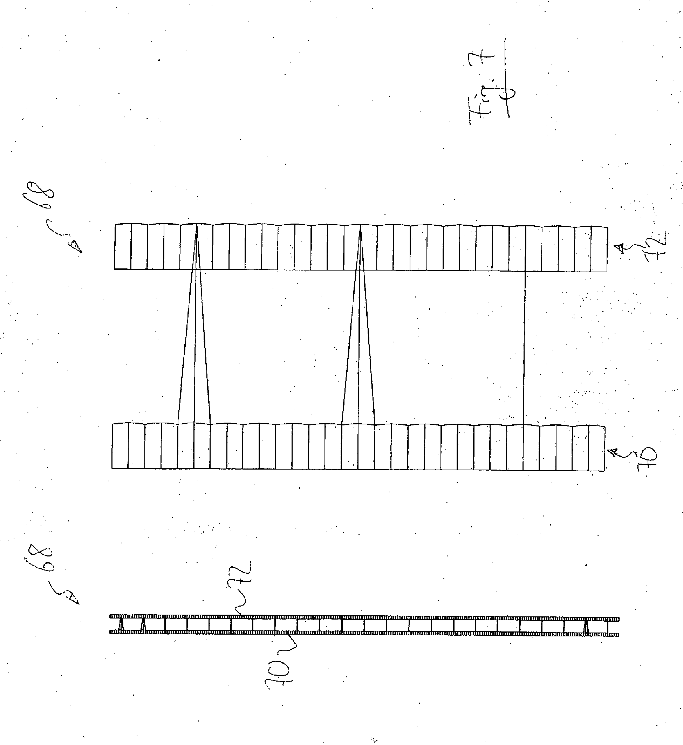

In Fig. 7 ist ein Ausführungsbeispiel der anamorphotischen Homogenisierungsoptik 68 näher dargestellt, wobei die Abbildung rechts eine teilweise Vergrößerung der Abbildung links repräsentiert. Wie zu erkennen ist, umfasst die anamorphotische Homogenisierungsoptik 68 zwei parallel zueinander angeordnete Zylinderlinsenarrays 70, 72. Eine derartige Homogenisierungsoptik 68 wird beispielsweise im hier in die Offenbarung eingeschlossenen Stand der Technik gemäß DE 42 20 705 A1, DE 38 29 728 A1 oder DE 102 25 674 A1 näher beschrieben.

Wie in Fig. 4 bis 6 gezeigt, umfasst die anamorphotische Optik 42 außerdem eine im Strahlengang hinter der anamorphotischen Homogenisierungsoptik 68 und dem ersten Zwischenbild 60 sowie im Strahlengang vor der Zylinderlinse 62 angeordnete Kondensorzylinderlinse 74, welche dazu eingerichtet ist, die anhand der anamorphotischen Homogenisierungsoptik 68 umverteilten und homogenisierten Laserstrahlen 40b telezentrisch auf die Beleuchtungslinie 44 zu lenken und bezüglich der langen Achse der Beleuchtungslinie 44 dort zu überlagern. Die Kombination aus anamorphotische Homogenisierungsoptik 68 und Kondensorzylinderlinse 74 erlaubt also die Formung der Einzelbeleuchtungslinien zu einer (Gesamt-) Beleuchtungslinie 44. Die telezentrische Abbildung der Kondensorzylinderlinse 74 ermöglicht es außerdem, eine Bildfeldkrümmung der Einzelbeleuchtungslinien zu vermeiden.

Die anamorphotische Optik 42 ist dazu eingerichtet, die Länge L_{F1} der ersten Faserachse der Lichtleitfasern 20 mit einem Abbildungsmaßstab A=N_{AL}/NA_{AO,1} auf die Länge L_{B1} der kurzen Achse der Beleuchtungslinie abzubilden, wobei NA_{L} die numerische Apertur des aus der Lichtleitfaser austretenden Lichtstrahls 40a und NA_{aO,1} die numerische Apertur der anamorphotischen Optik 42 bezüglich der ersten Faserachse/Abbildungsachse x ist. Beispielsweise ist NA_{AO,1}∼0,25 und NA_{L}∼0,12, so dass insbesondere gilt: A∼1/2, d.h. die Länge der kurzen Achse der Beleuchtungslinie 44 ist um einen Faktor 2 kürzer als die Lange L_{F1} der ersten Faserachse x.

Damit ergibt sich aus der Kombination der Lichtleitfasern 20 mit der in Fig. 2 und 3 beschriebenen optischen Einkopplungseinrichtung 22 und der in Fig. 4 bis 6 beschriebenen optischen Abbildungseinrichtung 24 folgender Vorteil: Die als Rechteckfasern ausgebildeten Lichtleitfasern 20 haben die Eigenschaft, beim Transport des Lichts durch die Lichtleitfaser 20 die numerischen Aperturen NA_{L1} und NA_{L2} des eingekoppelten Lichtstrahls 14c1, 14c2 zu mischen. Gilt etwa NA_{L1}>NA_{L2}, so wird der Lichtstrahl 40a und 40b bei Wiederaustritt aus der Lichtleitfaser 20 mit der größeren numerischen Apertur NA_{L1} entlang der ersten und der zweiten Faserachse x, y emittiert. Da anhand der optischen Einkopplungseinrichtung 22 die numerischen Aperturen NA_{L1} und NA_{L2} gezielt kleiner als ein Maximalwert NAₘₐₓ=0,12 gehalten werden, weisen die aus den Lichtleitfasern 20 wiederaustretenden Lichtstrahlen 40a und 40b entsprechend eine numerische Apertur NA_{L} auf, die ebenfalls kleiner als der Maximalwert NAₘₐₓ=0,12 ist. Somit kann man bereits auf der Eingangsseite der Lichtleitfasern 20 den Abbildungsmaßstab A=NA_{L}/NA_{AO,1} des optischen Abbildungseinrichtung 24 beeinflussen: Je kleiner NAₘₐₓ=0,12 fasereingangseitig eingestellt wird, desto schärfer und schmaler kann faserausgangsseitig die Beleuchtungslinie 44 erzeugt werden.

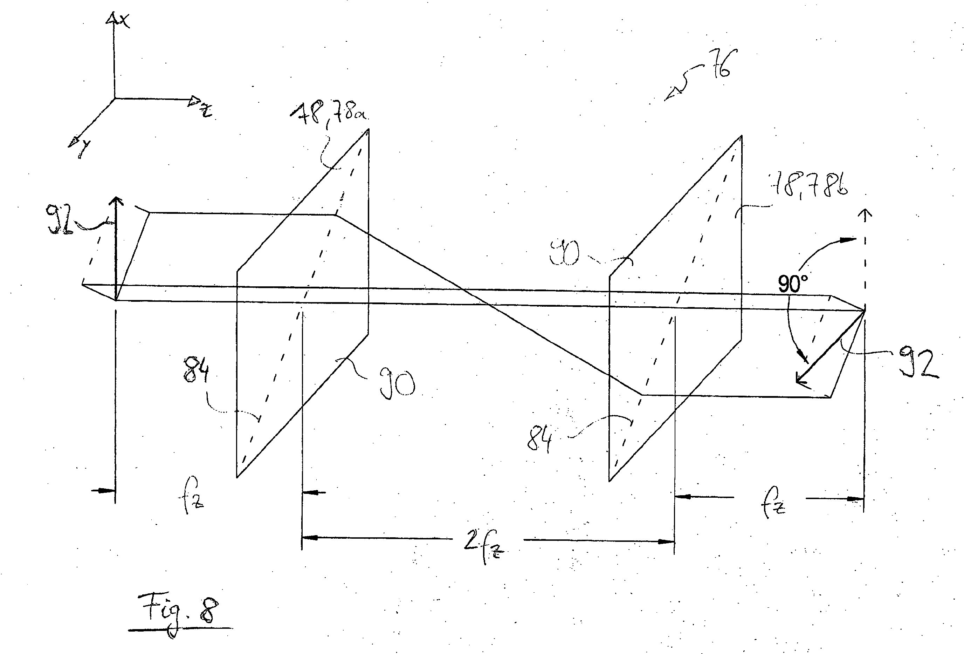

In Fig. 8 ist ein Ausführungsbeispiel einer Teleskopanordnung 76 gezeigt, welche zwei optische Elemente 78a, 78b umfasst.

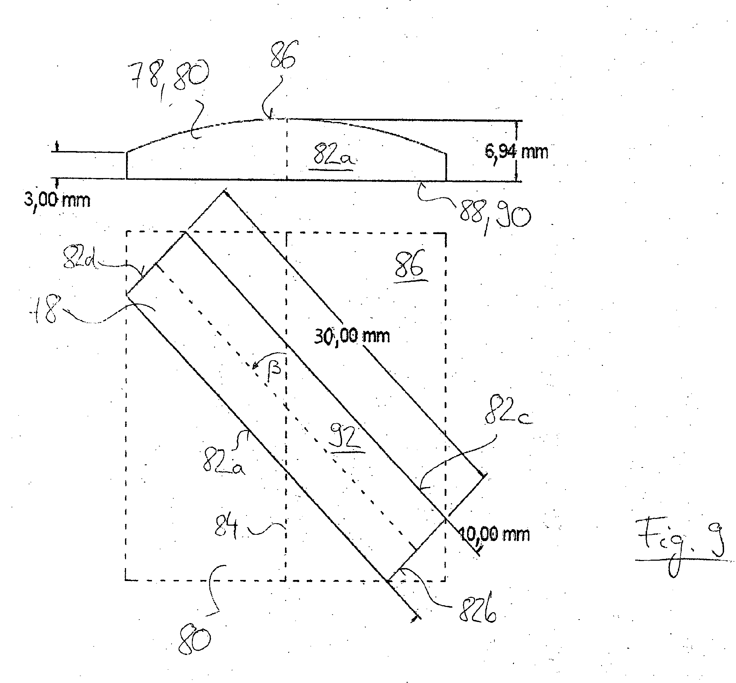

In Fig. 9 ist ein Ausführungsbeispiel zur Herstellung eines solchen optischen Elements 78 gezeigt. Das optische Element 78 ist erhältlich durch Schneiden einer Zylinderlinse 80. Die Zylinderlinse 80 und das daraus ausschneidbare optische Element 78 sind in Fig. 9 in Seitenansicht (oberer Bildteil) und in Draufsicht (unterer Bildteil) dargestellt.

Zur Herstellung des optischen Elements 78 wird die Zylinderlinse 80 vorzugsweise entlang von vier Schnittflächen 82a, 82b, 82c und 82d beschnitten. Die Schnittflächen 82a und 82c stehen jeweils schräg zur Zylindersymmetrieachse 84 der Zylinderlinse 80. Die Zylindersymmetrieachse 84 entspricht der Symmetrieachse, welche sich aus der Zylindersymmetrie einer zylindermantelförmigen Zylinderfläche 86 der Zylinderlinse 80 ergibt. Aus der zylindermantelförmigen Zylinderfläche 86 resultiert eine Brennweite f_{Z} der Zylinderlinse 80. Demnach ist das optische Element 78 selbst auch durch die Zylindersymmetrieachse 84 und durch die Brennweite f_{Z} charakterisierbar. Der Begriff "schräg" ist in dem Sinne zu verstehen, dass die Schnittflächen 82a, 82c und die Zylindersymmetrieachse 84 den Winkel β=45° einschließen.

Wie im Beispiel der Fig. 9 gezeigt, ist die Zylinderlinse 80 plan-konvex ausgebildet und weist eine ebene Grundfläche 88 und gegenüberliegend die zylindermantelförmigen Zylinderfläche 86 auf. Die Schnittflächen 82a-82d sind eben/plan ausgebildet und stehen zueinander orthogonal. Außerdem sind die Schnittflächen 82a-82d senkrecht zur ebenen Grundfläche 88 der Zylinderlinse 86 orientiert. Somit weist das optische Element 78 selbst auch eine ebene Grundfläche 90 und gegenüberliegend eine gekrümmte Fläche 92 auf, die sich an die Zylindermantelfläche 86 anschmiegen kann.

Wie in Fig. 8 gezeigt, werden in der Teleskopanordnung 76 die optischen Elemente 78a, 78b mit gleicher Brennweite f_{Z} im Abstand 2xf_{Z} zueinander derart angeordnet, dass die jeweiligen Zylindersymmetrieachsen 84 der optischen Elemente 78a, 78b parallel zueinander und die ebenen Grundflächen 90 parallel zueinander ausgerichtet sind. Dadurch ist die Teleskopanordnung 76 als ein Zylinderlinsenteleskop mit Abbildungsmaßstab 1:1 zu verstehen, das eine Drehung des Strahlprofils eines durch die Teleskopanordnung 76 hindurchtretenden Lichtstrahls um den Winkel 180°-2xβ=90° ermöglicht. Dies ist beispielhaft für eine Strahlachse 92 im Strahlprofil des durch die Teleskopanordnung 76 hindurchtretenden Lichtstrahls dargestellt.

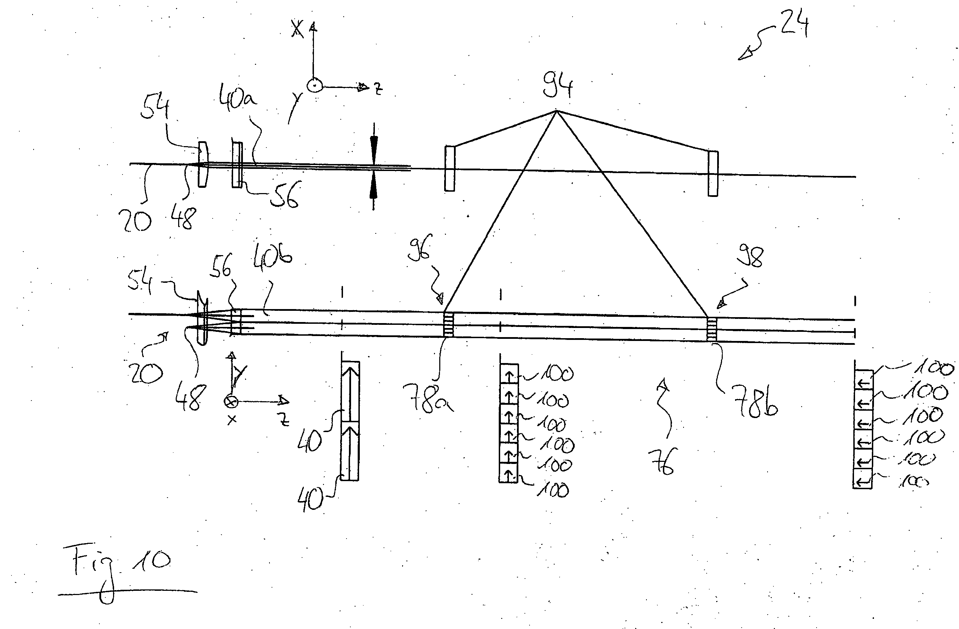

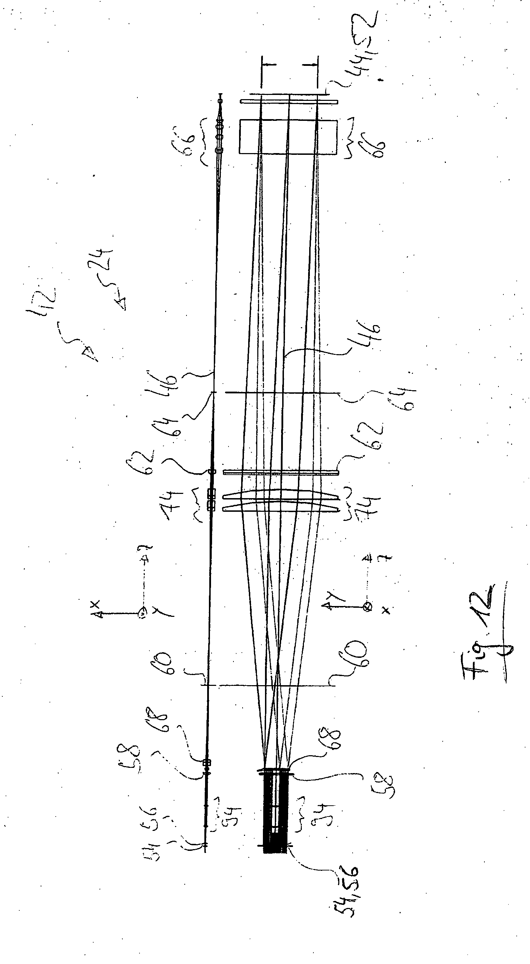

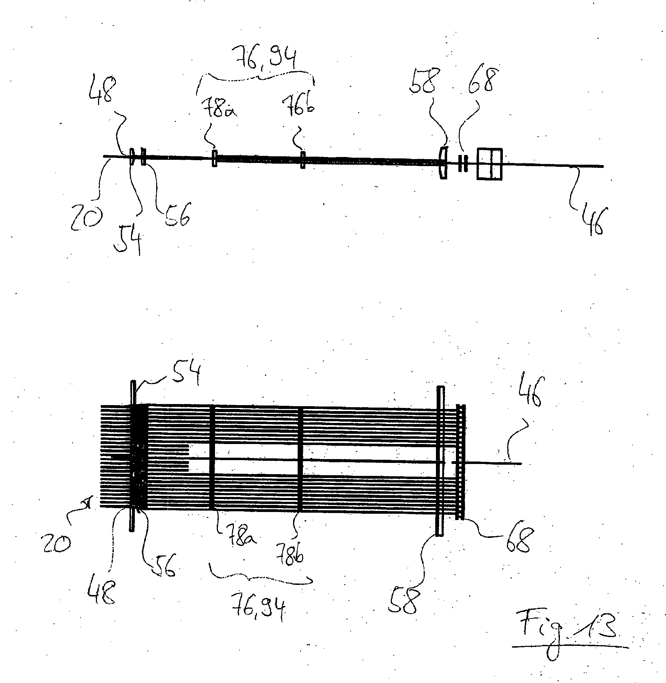

Mehrere Teleskopanordnung 76 können zu einer Transformationsoptik 94 zusammengesetzt werden. In Fig. 10 bis 13 sind Ausführungsbeispiele einer optischen Abbildungsvorrichtung 24 mit einer Transformationsoptik 94 gezeigt.

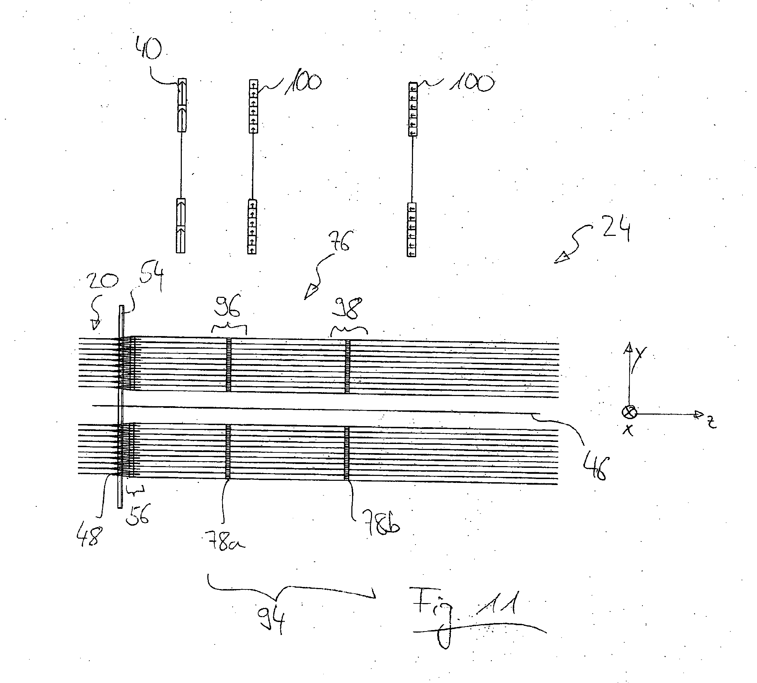

In dem in Fig. 10 und 11 dargestellten Ausführungsbeispielen umfasst die Transformationsoptik 94 exemplarisch eine Anzahl U=3 an Teleskopanordnungen 76 pro Lichtleitfaser 20. Dabei sind die im Strahlengang vorderen optischen Elemente 78a der Teleskopanordnungen 76 in einem ersten Array 96 derart zueinander angeordnet, dass die optischen Elemente 78 mit ihren ebenen Grundflächen 90 in der x-y-Ebene liegen und die Schnittflächen 82a, 82c benachbarter optischer Elemente 78a aneinander anliegen. Die im Strahlengang hinteren optischen Elemente 78b der Teleskopanordnungen 76 sind in einem zweiten Array 98 derart zueinander angeordnet, dass die optischen Elemente 78b mit ihren ebenen Grundflächen 90 ebenfalls in der x-y-Ebene liegen und die Schnittflächen 82a, 82c benachbarter optischer Elemente 78b aneinander anliegen. Jedes der Arrays 96, 98 kann somit als Stapel aus optischen Elementen 78a bzw. 78b verstanden werden.

Die Transformationsoptik 94 ist derart in der optischen Abbildungsvorrichtung 24 angeordnet, dass die Zylindersymmetrieachsen 84 der optischen Elemente 78a, 78b mit einer der Faserachsen x, y der Lichtleitfasern 20 den Winkel β=45° einschließen. Die Transformationsoptik 94 ist außerdem hinter der ersten Kollimationszylinderlinse 54 zur Kollimation der aus den Lichtleitfasern 20 bezüglich der ersten Faserachse x austretenden Lichtstrahlen 40a und der zweiten Kollimationszylinderlinse 56 zur Kollimation der aus den Lichtleitfasern 20 bezüglich der zweiten Faserachse y austretenden Lichtstrahlen 40b angeordnet. Somit treten in die Transformationsoptik 94 kollimierte Lichtstrahlen 40a, 40b ein.

Die so erhaltene Transformationsoptik 94 ist anhand der Teleskopanordnungen 76 und deren optischer Elemente 78a, 78b dazu eingerichtet, jeden in die Transformationsoptik 94 eintretenden kollimierten Lichtstrahl 40a, 40b mit schematischem Strahlprofil 40 in U=3 Teillichtstrahlen mit schematischem Strahlprofil 100 zu segmentieren und die einzelnen Stahlprofile 100 der Teillichtstrahlen derart umzuordnen, dass die Stahlprofile 100 der Teillichtstrahlen nach der Umordnung jeweils um die Propagationsrichtung des jeweiligen Teillichtstrahls um den Winkel 180°-2xβ=90° gedreht sind, wie schematisch in Fig. 10 und 11 anhand von kleinen Pfeilen veranschaulicht.

Letztendlich ist die Transformationsoptik 94 durch Verwendung der optischen Elemente 78a, 78b also dazu eingerichtet, einen durch die Transformationsoptik 94 hindurchtretenden Lichtstrahl 40a, 40b mit Strahlprofil 40 derart umzuordnen, dass das Strahlparameterprodukt des Lichtstrahls 40a, 40b nach der Umordnung um einen Faktor U=3 verkleinert ist. Der Faktor U bestimmt sich also aus der Anzahl U der zur Segmentierung des Lichtstrahls 40 herangezogenen Teleskopanordnungen 76. Anhand der durch die Transformationsoptik 94 bewirkten Umordnung ist es möglich, für eine vorgegebene maximale numerische Apertur NA_{AO} zur Erzeugung der Beleuchtungslinie 44 die Länge der kurzen Achse der Beleuchtungslinie 44 zu verkürzen und/oder die Tiefenschärfe der Beleuchtungslinie 44 im Bereich der Beleuchtungsebene 50 zu vergrößern.

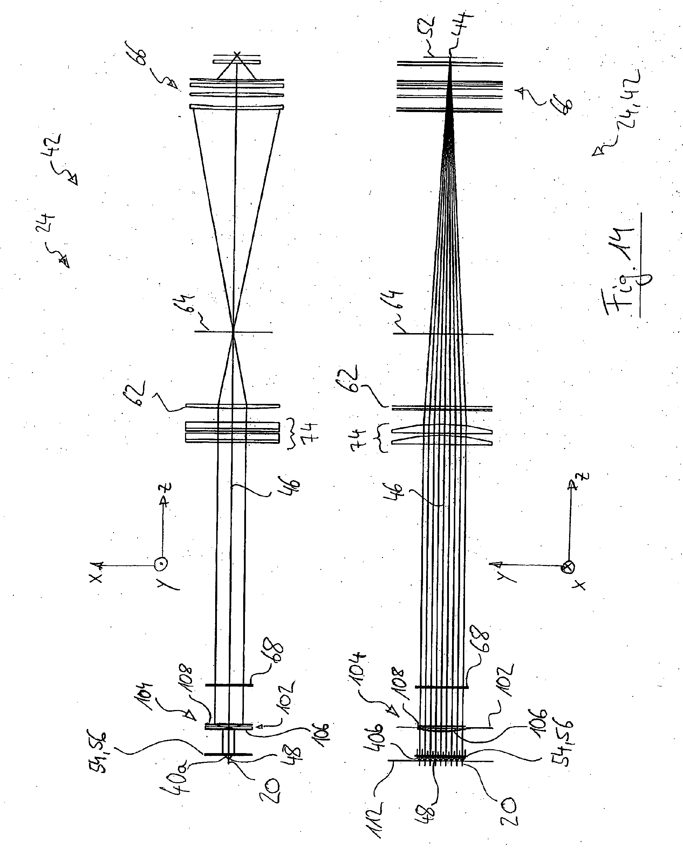

In Fig. 14 ist eine weitere Ausführungsform einer optischen Abbildungsvorrichtung 24 gezeigt. Diese Ausführungsform stellt eine mögliche Alternative zu der in Fig. 4 bzw. 5 gezeigten Ausführungsform dar.

Alternativ zu der in Fig. 4 bzw. 5 gezeigten Anordnung der Faseraustrittsflächen entlang einer gebogenen Referenzlinie 50, d.h. alternativ zu der in Fig. 4 bzw. 5 gezeigten Anordnung der anamorphotischen Optik 42 und der Lichtleitfasern 20 zueinander derart, dass die Zentren 48 der Strahltaillen der aus den Lichtleitfasern 20 austretenden Lichtstrahlen 40a, 40b entlang einer in einer Ebene liegenden gebogenen Referenzlinie 50 derart positioniert sind, dass die bezüglich der optischen Achse 46, die parallel zu den Propagationsrichtungen der aus den Lichtleitfasern 20 austretenden Lichtstrahlen 40a, 40b und durch den Schwerpunkt der Referenzlinie 50 verläuft, axialen Positionen der Zentren 48 sich mit größer werdenden radialen Abständen der Zentren 48 von der optischen Achse 46 in der axialen z-Richtung hin parallel zur optischen Achse 46 verlagert sind, kann zur Erzeugung einer Zwischenabbildung 102 bezüglich der ersten Faserachse/Strahlachse x eine Zylinderlinsenteleskopanordnung 104 vorgesehen sein. Dabei sind die Zylinderlinsenteleskopanordnung 104, die Zylinderlinse 62 und die Fokussierzylinderoptik 66 derart angeordnet und/oder dazu eingerichtet, den Strahlquerschnitt bezüglich der ersten Strahlachse x derart zu vergrößern, dass die Beleuchtungslinie 44 in der Beleuchtungsebene 52 eine gewünschte Linienbreite aufweist.

Die Zylinderlinsenteleskopanordnung 104 ist im Strahlengang der anamorphotischen Optik 42 zwischen der ersten und zweiten Kollimationszylinderlinse 54, 56 einerseits und der anamorphotischen Homogenisierungsoptik 68 anderseits angeordnet.

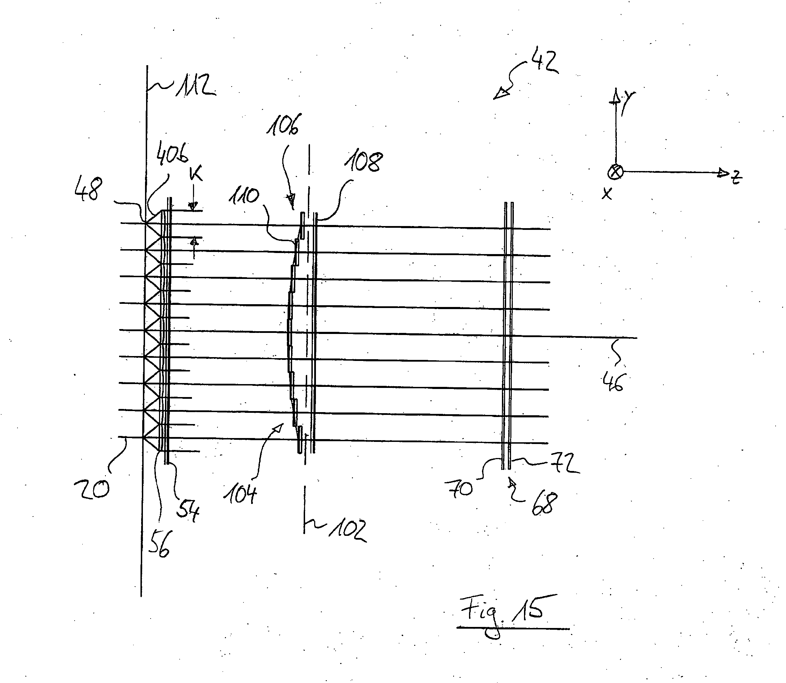

In Fig. 15 ist die Zylinderlinsenteleskopanordnung 104 aus Fig. 14 nochmals vergrößert. Die Zylinderlinsenteleskopanordnung 104 umfasst eine segmentierte Zylinderlinse 106 und eine nicht-segmentierte Zylinderlinse 108. Die segmentierte Zylinderlinsen 106 umfasst mehrere identische Zylinderlinsensegmente 110, wobei jeder Lichtleitfaser 20 ein Zylinderlinsensegment 110 zugeordnet ist. Dies ermöglicht eine Segmentierung des Strahlengangs innerhalb der anamorphotischen Optik 42.

Jedes Zylinderlinsensegment 110 ist als eine Zylinderlinse ausgestaltet, d.h. es weist eine bezüglich der ersten Strahlachse x brechende und eine bezüglich der zweiten Strahlachse y nicht-brechende Achse auf. Die Brennweiten der Zylinderlinsensegmente 110 bezüglich der ersten Strahlachse x sind identisch. Die Größe der Zylinderlinsensegmente 110 bezüglich der nicht-brechenden Achse des Zylinderlinsensegments entspricht der Länge K der zweiten Strahlachse y des aus einer Lidhtleitfaser austretenden und anhand der zweiten Kollimationszylinderlinse 56 kollimierten Lichtstrahls 40b. Der aus der Lichtleitfaser 20 bezüglich der ersten Faserachse x austretende und anhand der ersten Kollimationszylinderlinse 54 kollimierte Lichtstrahl 40a wird mit der Zylinderlinsenteleskopanordnung 104 optisch verarbeitet. Hierzu fokussiert das Zylinderlinsensegment 110 den kollimierten Lichtstrahl 40a bezüglich der ersten Strahlachse x auf die Zwischenabbildung 102, wie in Fig. 14, obere Hälfte gezeigt. Mit der nicht-segmentierten Zylinderlinse 108 der Zylinderlinsenteleskopanordnung 104 wird der von der Zwischenabbildung 102 ausgehende Laserstrahl 40a wieder kollimiert: Somit kann mit Hilfe der Zylinderlinse 62 und der Fokussierzylinderoptik 66 eine einzige scharfe Beleuchtungslinie 44 in der Beleuchtungsebene 52 gebildet werden.

Die einzelnen Zylinderlinsensegmente 110 der segmentierten Zylinderlinse 106 sind durch entsprechende (nicht dargestellte) Justagemittel der Zylinderlinsenteleskopanordnung 104 in Strahlrichtung z, d.h. entlang der optischen Achse 46 der anamorphotischen Optik 42, unabhängig voneinander justierbar ausgestaltet. Dies erlaubt es, unabhängig von dem Abstand der Lichtleitfasern 20 zur optischen Achse 46 der anamorphotischen Optik 42 die durch die aus den Lichtleitfasern 20 austretenden Lichtstrahlen gebildeten Beleuchtungslinien 44 in derselben Beleuchtungsebene 52 zu einer scharfen Beleuchtungslinie 44 zu überlagern, auch wenn die Lichtleitfasern 20 entlang einer Geraden 112 angeordnet sind. Dies hat den Vorteil, dass die Faserenden der Lichtleitfasern 20 in einer Ebene 112 angeordnet werden können (und nicht, wie in Fig. 4 bzw. 5 gezeigt, auf einer gebogenen Referenzlinie 50 angeordnet werden müssen). Damit kann die Anordnung der Lichtleitfasern 20 einfach gestaltet und die Überlagerung der einzelnen Beleuchtungslinien 44 durch das Justagemittel der Zylinderlinsenteleskopanordnung 104 bewerkstelligt werden.

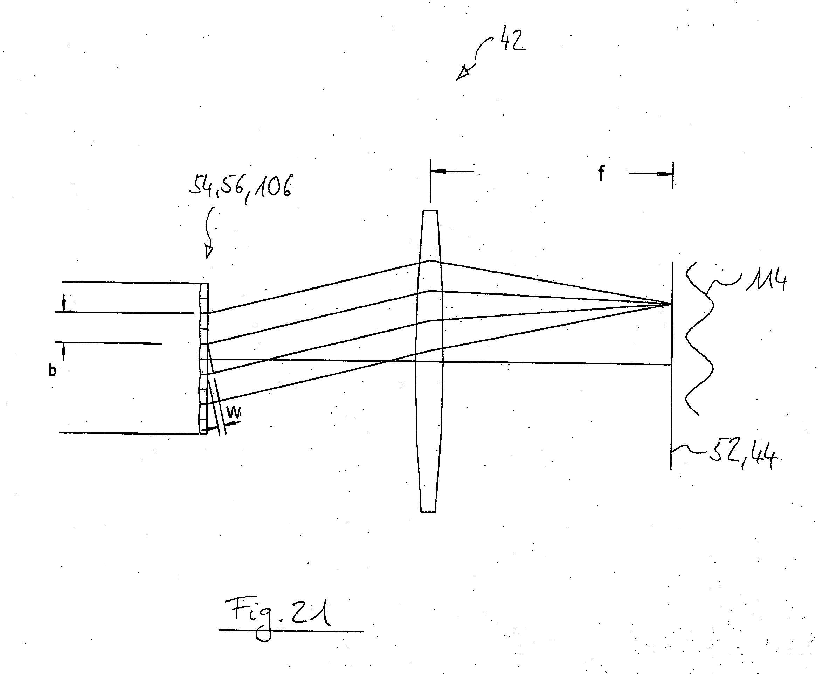

Die Qualität der erzeugten Beleuchtungslinie 44 hängt von mehreren Faktoren ab: Gewünscht ist zum einen eine möglichst homogene Intensitätsverteilung. Insbesondere durch die Kohärenz des Lichts verursachte Interferenzphänomene innerhalb der Beleuchtungslinie 44 gilt es zu unterdrücken. Ein solches Interferenzphänomen ist in Fig. 21 gezeigt. Dieses Interferenzphänomen entsteht dadurch, dass beispielsweise die Zylinderlinsen der Zylinderlinsenarrays 70, 72 der anamorphotischen Homogenisierungsoptik 68 als optisches Gitter wirken, an dem das aus einer (einzelnen) Lichtleitfaser 20 austretende kohärente Licht gebeugt werden kann. Daher kommt es nach Fokussierung der Lichtstrahlen auf die Beleuchtungslinie 44 in der Beleuchtungsebene 52 zu Intensitätsmodulationen 114. Diese gilt es zu unterdrücken oder gar völlig zu vermeiden.

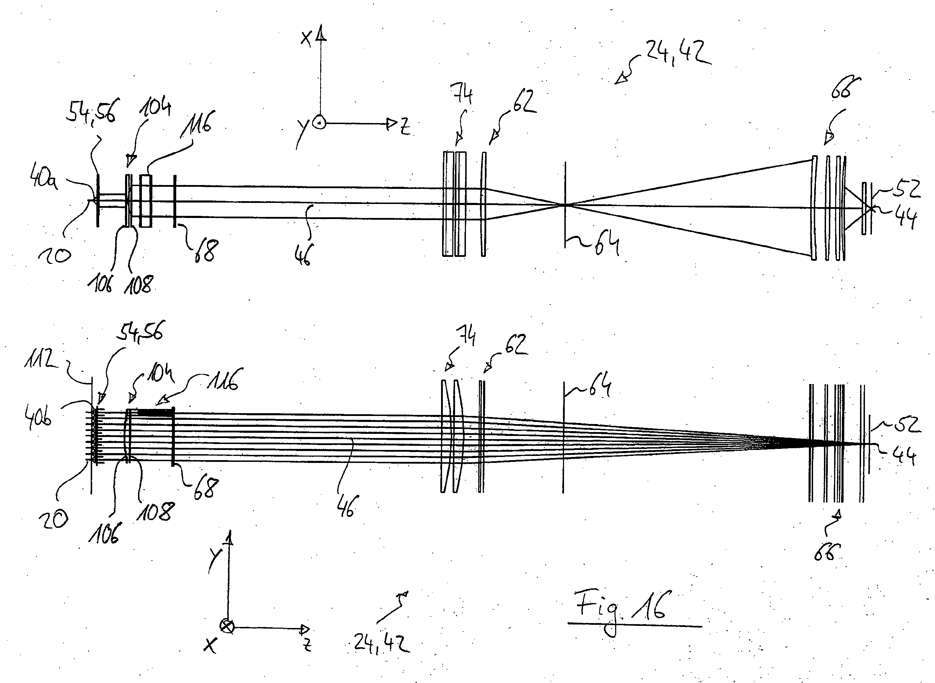

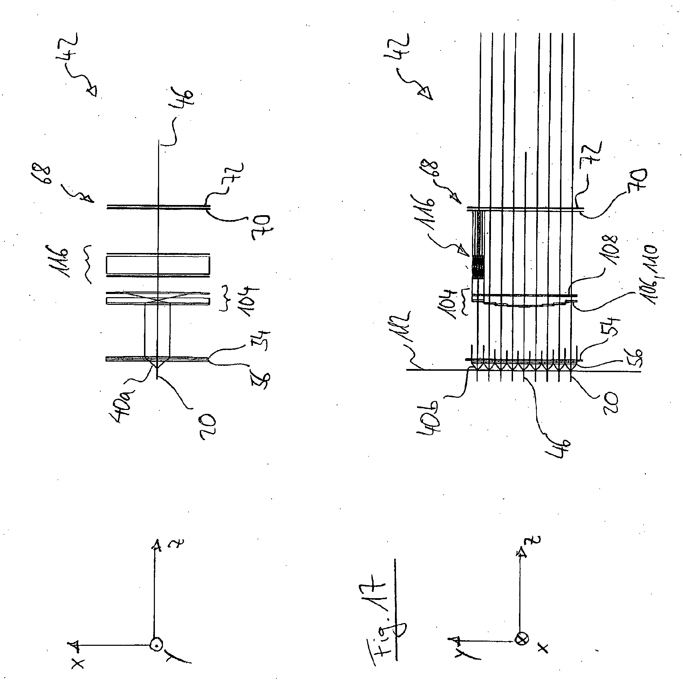

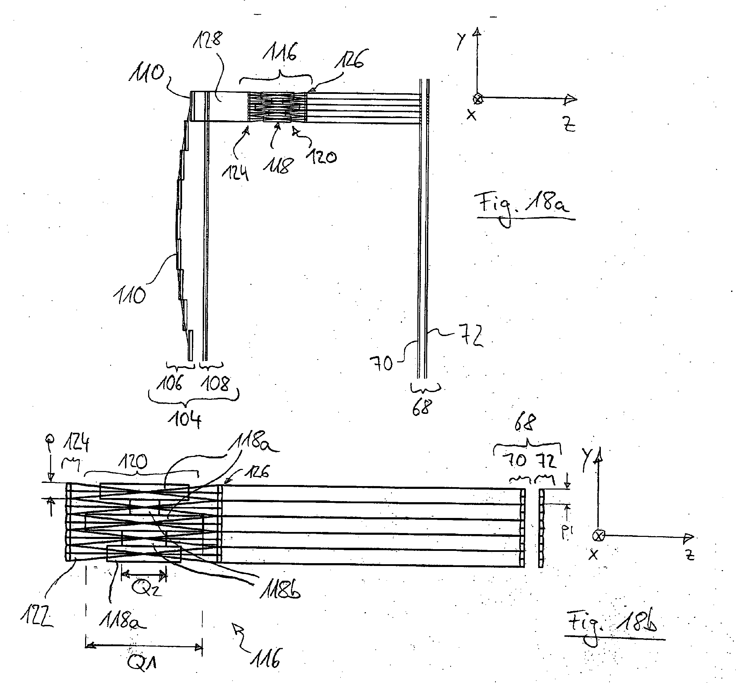

Hierzu kann eine Interferenzunterdrückungseinrichtung 116 vorgesehen sein, wie in Fig. 16 gezeigt. Die Interferenzunterdrückungseinrichtung 116 ist in den Fig. 17, 18a, und 18b nochmals vergrößert dargestellt.

Anzumerken ist, dass die Interferenzunterdrückungseinrichtung 116 selbst dann von Vorteil ist, wenn die Längen der Lichtleitfasern 20 untereinander derart unterschildlich gewählt sind, dass Längenunterschiede zwischen den Lichtleitfasern 20 jeweils größer sind als die Kohärenzlänge des zu transportierenden Lichts. Zwar können durch diese Wahl von Lichtleitfasern 20 mit solch unterschiedlichen Längen bei der Überlagerung der aus mehreren den Lichtleitfasern 20 austretenden Lichtstrahlen zur Beleuchtungslinie 44 Interferenzerscheinungen im Intensitätsmuster der Beleuchtungslinie 44 vermieden werden. Jedoch soll die Interferenzunterdrückungseinrichtung 116 in erster Linie die Interferenz an den als optisches Gitter wirkenden Zylinderlinsenarrays 70, 72 der anamorphischen Homogenisierungsoptik 68 reduzieren bzw. verhindern und zwar über jeweils den Bereich, der von dem Licht einer (einzelnen) Lichtleitfaser 20 bestrahlt wird.

Das bedeutet: Die Interferenzunterdrückungseinrichtung 116 ist derart ausgebildet und im Strahlengang der anamorphotischen Optik 42 derart angeordnet, dass z. B. an den Zylinderlinsen der Zylinderlinsenarrays 70, 72 der anamorphotischen Homogenisierungsoptik 68 durch Gitterbeugung des aus jeweils einer Lichtleitfaser 20 austretenden kohärenten Lichts 40a, 40b resultierende Interferenzphänomene unterdrückt oder vermieden werden. Mit anderen Worten: Die Interferenzunterdrückungseinrichtung 116 ist derart eingerichtet, dass in dem durch die Zylinderlinsen der Zylinderlinsenarrays 70, 72 hindurchtretenden Licht Laufzeitunterschiede bewirkt werden und die Zylinderlinsenarrays 70, 72 gerade nicht als optische Gitter wirken.

Die Interferenzunterdrückungseinrichtung 116 ist im Strahlengang der anamorphotischen Optik 42 zwischen den Kollimationszylinderlinsen 54, 56 einerseits und der anamorphotischen Homogenisierungsoptik 68 andererseits, genauer: zwischen der Zylinderlinsenteleskopanordnung 104 einerseits und der anamorphotischen Homogenisierungsoptik 68 andererseits angeordnet.

Wie insbesondere in Fig. 18a und 18b zu erkennen ist, umfasst die Intenferenzuriterdrückungseinrichtung 116 mehrere Glasblöcke 118, 118a, 118b. Die Glasblöcke 118, 118a, 118b sind als Quader säulenförmig bzw. stabförmig ausgebildet. Dabei sind für jedes Zylinderlinsensegment 110 der Zylinderlinsenteleskopanordnung 104 mehrere (im konkreten Beispiel fünf) Glasblöcke 118, 118a, 118b vorgesehen, die zu einem Glasblock-Array 120 zusammengefasst sind. Die Glasblöcke 118, 118a, 118b, insbesondere die Glasblöcke 118, 118a, 118b eines Glasblock-Arrays 120 weisen untereinander unterschiedliche geometrische Längen Q1, Q2 auf zur Erzeugung von optischen Laufwegunterschieden unter den sich zur Beleuchtungslinie 44 überlagernden Lichtbündeln 122, wobei die Laufwegunterschiede größer oder annähernd so groß sind wie die Kohärenzlänge des durch die anamorphotische Optik 42 zu verarbeitenden Lichts.

Die Interferenzunterdrückungseinrichtung 116 umfasst ferner für jeden Glasblock 118, 118a, 118b eine dem Glasblock 118, 18a, 118b im Strahlengang vorgeschaltete Zylinderlinse 124, welche das Licht in das Zentrum des Glasblocks 118, 118a, 118b fokussiert, siehe Fig. 18a und 18b. Dadurch kann zum Beispiel das aus einer Lichtleitfaser 20 austretende und durch die Kollimationszylinderlinse 54, 56 kollimierte Licht von einer Zylinderlinse 124 der Interferenzunterdrückungseinrichtung 116 fokussiert werden. Die Brennweite der Zylinderlinse 124 ist derart angepasst, dass der fokussierte Lichtstrahl den nachgeschalteten Glasblock 118, 118a, 118b entlang der gesamten geometrischen Länge Q1, Q2 durchläuft ohne dabei seitlich aus dem Glasblock 118, 118a, 118b auszutreten. Die Brennweiten aller Zylinderlinsen 124 der Interferenzunterdrückungseinrichtung 116 sind einheitlich und so gewählt, dass sie größer sind als die Kohärenzlänge des zu verarbeitenden Lichts und größer sind als etwa ein halb mal der geometrischen Länge des Glasblocks, der unter den Glasblöcken 118, 118a, 118b (insbesondere unter den Glasblöcken 118, 118a, 118b eines Glasblockarrays 120) die längste geometrische Länge aufweist. Die Brennweite jeder Zylinderlinse 124 beträgt zum Beispiel 80 mm. Die Breite P einer Zylinderlinse 124 bezüglich der zweiten Strahlachse y entspricht der Breite P' einer Zylinderlinse in der anamorphotischen Homogenisierungsoptik 68. Dies erlaubt eine verlustfreie Homogenisierung der Beleuchtungslinie 44.

Die Glasblöcke 118a eines ersten Teils der in einem Glasblock-Array 120 angeordneten Glasblöcke 118a, 118b weisen untereinander jeweils verschiedene geometrische Längen Q1 auf. Ebenso weisen die Glasblöcke 118b eines zweiten Teils der in dem Glasblock-Array 120 angeordneten Glasblöcke 118a, 118b untereinander jeweils verschiedene geometrische Längen Q2 auf. Dabei ist die geometrische Länge Q1 eines jeden Glasblocks 118a im ersten Teil des Glasblock-Arrays 120 länger ist als die geometrische Länge Q2 eines jeden Glasblocks 118b im zweiten Teil des Glasblock-Arrays 120. Ferner sind die Glasblöcke 118a, 118b im Glasblock-Array 120 derart angeordnet, dass in direkter Nachbarschaft zu jedem Glasblock 118a des ersten Teils ein Glasblock 118b des zweiten Teils, nicht jedoch ein anderer Glasblock 118a des ersten Teils angeordnet ist. Mit anderen Worten: Bilden die Glasblöcke 118a, 118b eines Glasblock-Arrays 120 einen Stapel, wie insbesondere in Fig. 18a und 18b gezeigt, so sind in diesem Stapel Glasblöcke 118a des ersten Teils im Wechsel mit Glasblöcken 118b des zweiten Teils angeordnet. Somit können die aus direkt benachbarten Glasblöcken 118a, 118b austretenden kohärenten Lichtstrahlen relative zueinander besonders gut verzögert werden. Dadurch können Interferenzphänomene besonders wirksam unterdrückt werden.

Wie in Fig. 18a und 18b gezeigt, kann die Interferenzunterdrückungseinrichtung 116 ferner im Strahlengang den Glasblöcken 118, 118a, 118b nachgeschaltete weitere Zylinderlinsen 126 aufweisen, wobei jedem Glasblock 118, 118a, 118b bzw. jeder dem Glasblock 118, 118a, 118b vorgeschalteten Zylinderlinse 124 eine weitere Zylinderlinse 126 zugeordnet ist. Jede Zylinderlinse 124 und die ihr zugeordnete weitere Zylinderlinse 126 können in Teleskopanordnung angeordnet sein, damit in die Zylinderlinse 124 eintretendes kollimiertes Licht nach zwischenzeitlicher Fokussierung im Glasblock 118, 118a, 118b nach Austritt aus der weiteren Zylinderlinse 126 wieder kollimiert (also re-kollimiert) ist. Hierbei wird die Brennweite der weiteren Zylinderlinse 126 an die geometrische Länge Q1, Q2 des Glasblocks 118, 118a, 118b angepasst. Die re-kollimierten Lichtstrahlen lassen sich anhand der Zylinderlinse 62 und der Fokussierzylinderoptik 66 besonders einfach zu der einen Beleuchtungslinie 44 in der Beleuchtungsebene 52 überlagern, wobei die Glasblöcke Interferenzphänomene in der Beleuchtungslinie 44 unterdrücken.

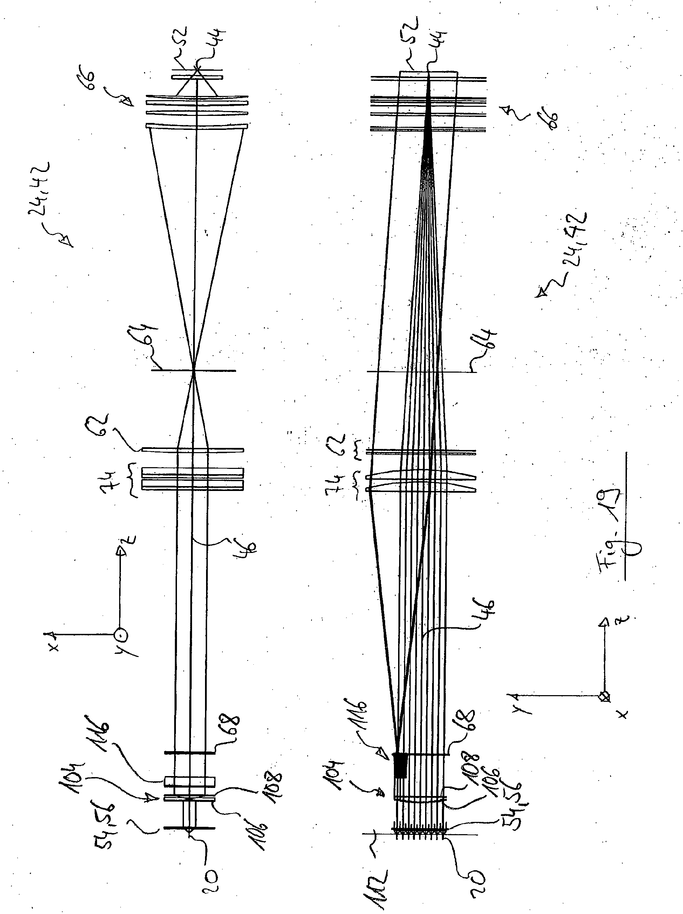

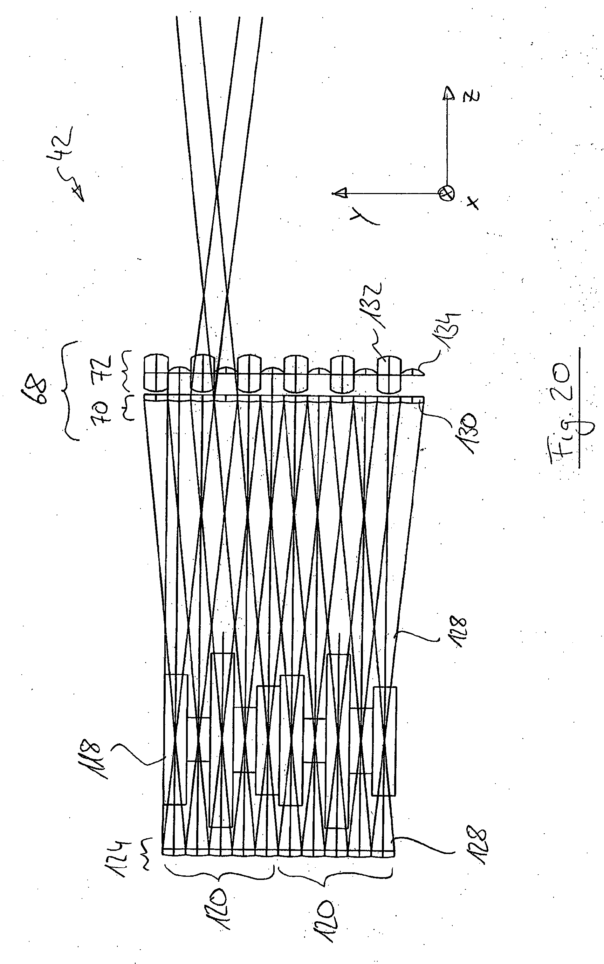

Alternativ zu der in Fig. 18a und 18b gezeigten Ausführungsform, kann in der Interferenzunterdrückungseinrichtung 116 aber auch gezielt auf die weiteren Zylinderlinsen 126 zur Re-kollimation verzichtet werden, siehe Fig. 19 und 20. In diesem Fall sind die den Glasblöcken 118, 118a, 118b im Strahlengang vorgeschalteten Zylinderlinsen 124 und die Glasblöcke 118, 118a, 118b derart angeordnet und ausgebildet, dass die in die Glasböcke 118, 118a, 118b bezüglich der zweiten Strahlachse y fokussierten Lichtstrahlen 128 bei Wiederaustritt aus den Glasblöcken 118, 118a, 118b Lichtkegel hinsichtlich der zweiten Strahlachse y bilden, welche jeweils mehrere Zylinderlinsen 130, 132, 134 des Zylinderlinsenarrays 70 bzw. 72 der anamorphotischen Homogenisierungsoptik 68 bestrahlen. Hierdurch wird jede Zylinderlinse 130, 132, 134 des Zylinderlinsenarrays 70 bzw. 72 der anamorphotischen Homogenisierungsoptik 68 mit Licht, das durch mehrere benachbarte Glasblöcke 118, 118a, 118b parallel hindurchgetreten ist, ausgeleuchtet. Dies führt zu einer weiter verbesserten Homogenisierung der Beleuchtungslinie 44.

Durch die in Fig. 19 und 20 gezeigte Ausgestaltung der Interferenzunterdrückungseinrichtung 116 treffen jedoch unter Umständen kohärente Strahlenteile auf beachbarte Zylinderlinsen 130 des Zylinderlinsenarrays 70 bzw. auf benachbarte Zylinderlinsen 132, 134 des Zylinderlinsenarrays 72. Dies kann zu den typischen Interferenzphänomenen, wie zum Beispiel Gittermodulationen, führen. Zur Vermeidung oder Unterdrückung dieser Interferenzphänomene ist das dem im Strahlengang dem ersten Zylinderlinsenarray 70 der anamorphotische Homogenisierungsoptik 68 nachgeschaltete zweite Zylinderlinsenarray 72 der anamorphotische Homogenisierungsoptik 68 abwechselnd aus dicken Zylinderlinsen 132 und dünnen Zylinderlinsen 134 gestapelt. Hierbei sind die dicken Zylinderlinsen 132 derart ausgebildet, dass deren abbildende Eigenschaften, Brennweiten und Hauptebenen denen der dünnen Zylinderlinsen 134 entsprechen. Insbesondere sind die dicken Zylinderlinsen 132 derart ausgebildet, dass sie dieselben optischen Abbildungseigenschaften wie die dünnen Zylinderlinsen 134 aufweisen, jedoch im Vergleich zu diesen einen Laufwegunterschied in der Größenordnung der Kohärenzlänge des zu verarbeitenden Lichts 128 bewirken. Die dünnen Zylinderlinsen 134 wiesen im konkreten Beispiel einen (Krümmungs-) Radius von 10 mm und eine Linsendicke von 3 mm auf. Die dicken Zylinderlinsen 132 sind jeweils in Form einer bikonvexen Linse mit einem (Krümmungs-) Radius von 20 mm und einer Linsendicke von 40 mm ausgebildet und weisen daher annähernd dieselben Abbildungseigenschaften wie die dünnen Zylinderlinsen 134 auf, erzeugen jedoch im Vergleich zu den Zylinderlinsen 134 einen Laufwegunterschied von etwa 20 mm bei einem Brechungsindex von 1,5. Dies führt dazu, dass die dicken Zylinderlinsen 132 einen Laufwegunterschied in den zur Beleuchtungslinie 44 zu überlagernden Lichtstrahlen 130 verursachen und somit zur Unterdrückung der konstruktiven/destruktiven Interferenz beitragen. Somit wird eine besonders gute Homogenisierung der Beleuchtungslinie ermöglicht.

Sofern nicht ausdrücklich unterschiedlich benannt, stehen in den Figuren gleiche Bezugszeichen für gleiche oder gleichwirkende Elemente. Im Übrigen ist eine beliebige Kombination der in den Figuren im Zusammenhang mit einzelnen Ausführungsbeispielen erläuterten Merkmale möglich.

## Patentansprüche

1. Optisches System (16) für eine Anlage zur Bearbeitung von Dünnfilmschichten, umfassend:
- eine Mehrzahl Lichtleitfasern (20) zum Leiten von Licht, insbesondere Laserlicht,
- mindestens eine optische Einkopplungseinrichtung (22) zum Einkoppeln des Lichts in die Lichtleitfasern (20), und
- eine optische Abbildungseinrichtung (24) zur Erzeugung einer mit aus den Lichtleitfasern (20) austretenden Lichtstrahlen (14'; 40; 40a, 40b) gebildeten, eine lange Achse und eine kurze Achse aufweisenden Beleuchtungslinie (44) in einer Beleuchtungsebene (52), **dadurch gekennzeichnet, dass** jede der Lichtleitfasern (20) einen rechteckförmigen Querschnitt mit einer kurzen Faserachse (x) und einer langen Faserachse (y) aufweist, und
dass die optische Abbildungseinrichtung (24) eine anamorphotische Optik (42) umfasst, die dazu eingerichtet ist, die aus den Lichtleitfasern (20) austretenden Lichtstrahlen (40a, 40b) bezüglich der kurzen Faserachse (x) auf die kurze Achse der Beleuchtungslinie (44) zu fokussieren und bezüglich der langen Faserachse (y) in der Beleuchtungslinie (44) homogenisiert zu überlagern.

2. Optisches System nach Anspruch 1, wobei die optische Einkopplungseinrichtung (22) mindestens einen im Strahlengang eines Lichtstrahls (14b) angeordneten Strahlteiler (32) umfasst, der dazu eingerichtet ist, den Lichtstrahl (14b) geometrisch in mindestens einen ersten und einen zweiten Teillichtstrahl (14c1, 14c2) derart aufzuteilen, dass das Verhältnis aus der Beugungsmaßzahl M_{L1}² bezüglich einer ersten Strahlachse im Strahlprofil eines Teillichtstrahls (14c1, 14c2) und der Beugungsmaßzahl M_{L2}² bezüglich einer zur ersten Strahlachse senkrechten zweiten Strahlachse im Strahlprofil des Teillichtstrahls (14c1, 14c2) an ein vorgegebenes Verhältnis T=M_{L1}²: M_{L2}² angepasst ist, wobei insbesondere T∼0,5 oder T∼2.

3. Optisches System nach Anspruch 2, wobei der Strahlteiler (32) mindestens eine Spiegelfläche (34) mit einer scharfen insbesondere geradlinigen Spiegelflächenkante aufweist, wobei die Spiegelfläche (34) entlang einer der beiden ersten und zweiten Strahlenachsen des Lichtstrahls (14b) von einer Richtung her nur derart weit in den Lichtstrahl (14b) hineinragt, dass die Spiegelfläche (34) nur einen Teil der ersten bzw. zweiten Strahlachse des Lichtstrahls (14b) abdeckt, dessen Länge im Vergleich zur gesamten Länge der ersten bzw. zweiten Strahlachse des Lichtstrahls (14b) um den Faktor T kürzer ist.

4. Optisches System nach einem der vorhergehenden Ansprüche, wobei die optische Einkopplungseinrichtung (22) eine Kollimations- und Aufweitungsoptik (28, 30) umfasst, die dazu eingerichtet ist, einen Lichtstrahl (14) in einen umgeformten, insbesondere kollimierten Lichtstrahl (14b) derart umzuformen, dass der umgeformte Lichtstrahl (14b) ein Strahlprofil aufweist, in dem die Länge L'_{L1} einer ersten Strahlachse einer vorgegebenen ersten Länge und die Länge L'_{L2} einer zur ersten Strahlachse senkrechten zweiten Strahlachse einer vorgegebenen zweiten Länge entspricht und/oder die Länge L'_{L1} der ersten Strahlachse im Verhältnis zur Länge L'_{L2} der zweiten Strahlachse einem vorgegebenen Aspektverhältnis Y_{L} = L'_{L1}:L'_{L2} entspricht, wobei insbesondere das Aspektverhältnis Y_{L}=L'_{L1}:L'_{L2} im Strahlprofil des umgeformten Lichtstrahls im Wesentlichen dem aus der Länge L_{F1} einer ersten Faserachse im Querschnitt (26) einer Lichtleitfaser (20) und der Länge L_{F2} einer zur ersten Faserachse senkrechten zweiten Faserachse im Querschnitt (26) der Lichtleitfaser (20) gebildeten Aspektverhältnis Y_{F}=L_{F1}:L_{F2} entspricht, Y_{L}∼Y_{F}.

5. Optisches System nach einem der vorhergehenden Ansprüche, wobei die optische Einkopplungseinrichtung (22) eine Einkoppeloptik (38) zum Fokussieren eines Lichtstrahls (14c1, 14c2) in eine Lichtleitfaser (20) umfasst, wobei die Einkoppeloptik (38) insbesondere als korrigierte asphärische Linse mit einer Brennweite f ausgebildet ist.

6. Optisches System nach einem der vorhergehenden Ansprüche, wobei eine Kollimations- und Aufweitungsoptik (28, 30), ein Strahlteiler (32) und eine Einkoppeloptik (38) dazu eingerichtet sind, die Teillichtstrahlen (14c1, 14c2) in die Lichtleitfasern (20) derart einzukoppeln, dass die Länge L_{L1} der ersten Strahlachse im Strahlprofil eines Teillichtstrahls (14c1, 14c2) an die Länge L_{F1} der ersten Faserachse im Querschnitt (26) einer Lichtleitfaser (20) und die Länge L_{L2} der zweiten Strahlachse im Strahlprofil des Teillichtstrahls (14c1, 14c2) an die Länge L_{F2} der zweiten Faserachse im Querschnitt (26) der Lichtleitfaser (20) bei Eintritt des Teillichtstrahls (14c1, 14c2) in die Lichtleitfaser (20) angepasst sind, wobei insbesondere L_{L1}=ηxL_{F1} und L_{L1}=ηxL_{F1} mit einem vorgegebenen Wert 0≤η≤1, z.B. η=60-70%.

7. Optisches System nach einem der vorhergehenden Ansprüche, wobei eine Kollimations- und Aufweitungsoptik (28, 30), ein Strahlteiler (32) und eine Einkoppeloptik (38) dazu eingerichtet sind, die Teillichtstrahlen (14c1, 14c2) in die Lichtleitfasern (20) derart einzukoppeln, dass die numerischen Apertur NA_{L1} bezüglich der ersten Strahlachse eines Teillichtstrahls (14c1, 14c2) der numerischen Apertur NA_{F} einer Lichtleitfaser (20) oder einem vorgegeben ersten Maximalwert NA_{max,1} entspricht und die numerische Apertur NA_{L2} bezüglich der zweiten Strahlachse des Teillichtstrahls (14c1, 14c2) der numerischen Apertur NA_{F} der Lichtleitfaser (20) oder einem vorgegebenen zweiten Maximalwert NA_{max,2} entspricht, wobei insbesondere NA_{max,1}∼NA_{max,2} oder NA_{max,1}∼2xNA_{max,2} und/oder NA_{max,1}=0,12.

8. Optisches System nach einem der vorhergehenden Ansprüche, wobei die Lichtleitfasern (20) zueinander derart angeordnet sind, dass Propagationsrichtungen der aus den Lichtleitfasern (20) austretenden Lichtstrahlen (40a, 40b) parallel zueinander orientiert sind und die Zentren (48) der Strahltaillen der aus den Lichtleitfasern (20) austretenden Lichtstrahlen (40a, 40b) entlang einer in einer Ebene (y-z) liegenden gebogenen Referenzlinie (50) derart positioniert sind, dass die bezüglich einer Geraden (46), die parallel zu den Propagationsrichtungen und durch den Schwerpunkt der Referenzlinie (50) verläuft, axialen Positionen der Zentren (48) sich mit größer werdenden radialen Abständen der Zentren (48) von der Geraden (46) in einer Richtung (z) hin parallel zur Geraden (46) verlagert sind.

9. Optisches System nach einem der vorhergehenden Ansprüche, wobei die anamorphotische Optik (42) und die Lichtleitfasern (20) zueinander derart angeordnet sind, dass für jede Lichtleitfaser (20) der aus dieser Lichtleitfaser (20) austretende Lichtstrahl (40a, 40b) unabhängig vom radialen Abstand des Zentrums (48) der Strahltaille von der optischen Achse (46) der anamorphotischen Optik (42) auf die Beleuchtungsebene (52) fokussiert wird.

10. Optisches System nach einem der vorhergehenden Ansprüche, wobei Justagemittel vorgesehen sind, die dazu eingerichtet sind, die Lichtleitfasern (20) derart räumlich justierbar zu lagern, dass zumindest die Abstände der Zentren (48) der Strahltaillen der aus den Lichtleitfasern (20) austretenden Lichtstrahlen (40a, 40b) relativ zur anamorphotische Optik (42) unabhängig voneinander einstellbar sind.

11. Optisches System nach einem der vorhergehenden Ansprüche, wobei die anamorphotische Optik umfasst:
- eine erste Kollimationszylinderlinse (54) zur Kollimation der aus den Lichtleitfasern (20) bezüglich der ersten Faserachse (x) austretenden Lichtstrahlen (40a),
- eine zweite Kollimationszylinderlinse (56) zur Kollimation der aus den Lichtleitfasern (20) bezüglich der zweiten Faserachse (y) austretenden Lichtstrahlen (40b),
- eine im Strahlengang hinter der ersten Kollimationszylinderlinse (54) angeordnete Zylinderlinse (58) zur Fokussierung der Lichtstrahlen (40a) bezüglich der ersten Faserachse (x) auf ein erstes Zwischenbild (60),
- eine im Strahlengang hinter dem ersten Zwischenbild (60) angeordnete weitere Zylinderlinse (62) zur Fokussierung der Lichtstrahlen (40a) bezüglich der ersten Faserachse (x) auf ein zweites Zwischenbild (64),
- eine im Strahlengang hinter dem zweiten Zwischenbild (64) angeordnete Fokussierungszylinderoptik (66) zur Fokussierung der Lichtstrahlen (40a) bezüglich der ersten Faserachse (x) auf die Beleuchtungslinie (44),
- eine im Strahlengang hinter der Zylinderlinse (58) zur Fokussierung der Lichtstrahlen (40a) bezüglich der ersten Faserachse (x) auf das erste Zwischenbild (60) angeordnete anamorphotische Homogenisierungsoptik (68) zur Homogenisierung der aus den Lichtleitfasern (20) bezüglich der zweiten Faserachse (y) austretenden Lichtstrahlen (40b), und/oder
- eine im Strahlengang hinter der anamorphotischen Homogenisierungsoptik (68) angeordnete Kondensorzylinderlinse (74) zur Überlagerung der homogenisierten Lichtstrahlen (40b) auf der Beleuchtungslinie (44).

12. Optisches System nach Anspruch 11, wobei die Kondensorzylinderlinse (74) dazu eingerichtet ist, die homogenisierten Lichtstrahlen (40b) telezentrisch auf die, Beleuchtungslinie (44) zu lenken.

13. Optisches System nach einem der vorhergehenden Ansprüche, wobei jede der Lichtleitfasern (20) als eine Rechteckfaser ausgebildet ist, deren Kern und/oder Mantel einen Querschnitt (26) in Rechteckform mit einer kurzen Rechteckachse und mit einer langen Rechteckachse aufweist.

14. Optisches System nach einem der vorhergehenden Ansprüche, ferner umfassend eine Zylinderlinsenteleskopanordnung (104) mit einer segmentierten Zylinderlinse (106), die mehrere durch Justagemittel der Zylinderlinsenteleskopanordnung (104) in Strahlrichtung unabhängig voneinander justierbare Zylinderlinsensegmente (110) aufweist.

15. Optisches System nach einem der vorhergehenden Ansprüche, ferner umfassend eine Interferenzunterdrückungseinrichtung (116) mit mehreren zu GlasblockArrays (120) zusammengefassten Glasblöcken (118, 118a 118b), wobei die Glasblöcke (118a) eines ersten Teils der in einem Glasblock-Array (120) angeordneten Glasblöcke (118, 118a, 118b) untereinander jeweils verschiedene geometrische Längen (Ql) aufweisen, die Glasblöcke (118b) eines zweiten Teils der in dem Glasblock-Array (120) angeordneten Glasblöcke (118, 118a, 118b) untereinander jeweils verschiedene geometrische Längen (Q2) aufweisen und die geometrische Länge (Q1) eines jeden Glasblocks (118a) im ersten Teil des Glasblock-Arrays (120) länger ist als die geometrische Länge (Q2) eines jeden Glasblocks (118b) im zweiten Teil des Glasblock-Arrays (120), und wobei die Glasblöcke (118, 118a, 118b) im Glasblock-Array (120) derart angeordnet sind, dass in direkter Nachbarschaft zu jedem Glasblock (118a) des ersten Teils ein Glasblock (118b) des zweiten Teils, nicht jedoch ein anderer Glasblock (118a) des ersten Teils angeordnet ist.

16. Anlage (10) zur Bearbeitung von Dünnfilmschichten, umfassend:
- mindestens einen Laser (12) zur Erzeugung eines Lichtstrahls (14),
- einen Träger, auf welchen eine Materialschicht aufbringbar oder aufgebracht ist, und
- ein optisches System (16) nach einem der Ansprüche 1 bis 15,
wobei die Anlage dazu ausgebildet und angeordnet ist, die Materialschicht mit dem durch die Mehrzahl Lichtleitfasern (20) des optischen Systems geleiteten Lichtstrahl (14') zu beaufschlagen, um die Materialschicht zumindest durch kurzzeitiges Aufschmelzen zu verarbeiten.

## Claims

1. An optical system (16) for an apparatus for processing thin-film layers, comprising:
- a plurality of optical fibers (20) for guiding light, in particular laser light,
- at least one optical light-incoupling device (22) for coupling the light into the optical fibers (20), and
- an optical imaging device (24) for generating in an illumination plane (52) an illumination line (44) that is formed by light beams (14'; 40; 40a, 40b) emanating from the optical fibers (20), and that has a long axis and a short axis,
**characterized in**
**that** each of the optical fiber (20) has a rectangular cross-section with a short fiber axis (x) and a long fiber axis (y) and
**that** the optical imaging device (24) comprises an anamorphic lens (42) that is configured to focus the light beams (40a, 40b) emanating from the optical fibers (20) with respect to the short fiber axis (x) onto the short axis of the illumination line (44) and to superimpose them in a homogenized manner relative to the long fiber axis (y) in the illumination line (44).

2. The optical system according to claim 1, wherein the optical light-incoupling device (22) comprises at least one beam splitter (32) located in the light path of a light beam (14b), which is configured to split the light beam (14b) in a geometrical manner into at least one first and one second beamlet (14c1, 14c2) such that the ratio of the Beam Propagation Ratio M_{L1}² relative to a first beam axis in the beam profile of a beamlet (14c1, 14c2) to the Beam Propagation Ratio M_{L2}² relative to a second beam axis in the beam profile of the beamlet (14c1, 14c2), said second axis being perpendicular to the first beam axis, is adjusted to a predetermined ratio T = M_{L1}²: M_{L2}², wherein in particular T∼ 0.5 or T∼ 2.

3. The optical system according to claim 2, wherein the beam splitter (32) comprises at least one mirror surface (34) having a sharp, especially straight mirror surface edge, wherein the mirror surface (34) along one of the two first and second beam axes of the light beam (14b) extends from one direction into the light beam (14b) only so far that the mirror surface (34) covers only a segment of the first or second beam axis of the first light beam (14b), the length of which relative to the entire length of the first or second beam axis of the light beam (14b) is shorter by the factor T.

4. The optical system according to any one of the preceding claims, wherein the optical light-incoupling device (22) comprises a collimation and expanding lens (28, 30) that is configured to transform a light beam (14) into a transformed, especially collimated light beam (14b) such that the transformed light beam (14b) has a beam profile, wherein the length L'_{L1} of a first beam axis corresponds to a predetermined first length and the length L'_{L2} of a second beam axis that is perpendicular to the first beam axis corresponds to a predetermined second length and/or the length L'_{L1} of the first beam axis relative to the length L'_{L2} of the second beam axis corresponds to a predetermined aspect ratio Y_{L}= L'_{L1}:L'_{L2}, wherein especially the aspect ratio Y_{L}= L'_{L1}:L'_{L2} in the beam profile of the transformed light beam substantially corresponds to the aspect ratio Y_{F}=L_{F1}:L_{F2} resulting from the length L_{F1} of a first fiber axis in the cross-section (26) of an optical fiber (20) and the length L_{F2} of a second fiber axis being perpendicular to the first fiber axis in the cross-section (26) of the optical fiber (20) Y_{L}∼Y_{F}.

5. The optical system according to any one of the preceding claims, wherein the optical light-incoupling device (22) comprises a light-incoupling lens (38) for focusing a beamlet (14c1), 14c2) into an optical fiber (20), wherein the light-incoupling lens (38) is especially designed as a corrected aspheric lens with a focal length f.

6. The optical system according to any one of the preceding claims, wherein a collimation and expanding lens (28, 30), a beam splitter (32) and a light-incoupling lens (38) are configured to couple the beamlets (14c1, 14c2) into the optical fibers (20) such that the length L_{L1} of the first beam axis in the beam profile of a beamlet (14c1, 14c2) is adjusted to the length L_{F1} of the first fiber axis in the cross-section (26) of an optical fiber (20) and the length L_{L2} of the second beam axis in the beam profile of the beamlet (14c1, 14c2) is adjusted to the length L_{F2} of the second fiber axis in the cross-section (26) of the optical fiber (20) when the beamlet (14c1, 14c2) enters into the optical fiber (20), wherein especially L_{L1}= 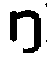 XL_{F1} and L_{L1}= 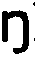 XL_{F1} having a predetermined value of 0≤ 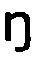 ≤1, for example, 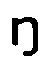 =60 to 70 percent.

7. The optical system according to any one of the preceding claims, wherein a collimation and expanding lens (28, 30), a beam splitter (32) and a light-incoupling lens (38) are configured to couple the beamlets (14c1), 14c2) into the optical fibers (20) such that the numerical aperture NA_{L1} relative to the first beam axis of a beamlet (14c1, 14c2) corresponds to the numerical aperture NA_{F} of an optical fiber (20) or to a predetermined first maximum value NA_{max,1} and the numerical aperture NA_{L2} relative to the second beam axis of the beamlet (14c1, 14c2) corresponds to the numerical aperture NA_{F} of the optical fiber (20) or to a predetermined maximum value NA_{max,2}, wherein especially NA_{max,1}∼NA_{max,2} or NA_{max,1}∼2xNA_{max,2} and/or NA_{max,1}=0.12.

8. The optical system according to any one of the preceding claims, wherein the optical fibers (20) are arranged relative to one another such that propagation directions of the light beams (40a, 40b) emanating from the optical fibers (20) are oriented parallel to one another and the centers (48) of the beam waists of the light beams (40a, 40b) emanating from the optical fibers (20) are positioned along a curved reference line (50) laying in a plane (x-y) such that the positions of the centers (48) that with respect to a straight line (46) are axial, said straight line running parallel to the propagation directions and through the centroid of the reference line (50), are displaced by increasing radial distances of the centers (48) from the straight line (46) into a direction (z) to being parallel to the straight line (46).

9. The optical system according to any one of the preceding claims, wherein the anamorphic lens (42) and the optical fibers (20) are positioned relative to one another such that for each optical fiber (20) the light beam (40a, 40b) emanating from the said optical fiber (20) is focused into the illumination plane (52), independently from the radial distance of the center (48) of the beam waist from the optical axis (46) of the anamorphic lens (42).

10. The optical system according to any one of the preceding claims, wherein adjusting means are provided which are configured so as to position the optical fibers (20) spatially adjustable such that at least the distances of the centers (48) of the beam waists of the light beams (40a, 40b) emanating from the optical fibers (20) are adjustable relative to the anamorphic lens (42), independently from each other.

11. The optical system according to any one of the preceding claims, wherein the anamorphic lens comprises:
- a first cylindrical collimation lens (54) for collimating the light beams (40a) emanating from the optical fibers (20) relative to the first fiber axis (x),
- a second cylindrical collimation lens (56) for collimating the light beams (40b) emanating from the optical fibers (20) relative to the second fiber axis (y),
- cylindrical lens (58) located in the light path behind the first cylindrical collimation lens (54) for focusing the light beams (40a) relative to the first fiber axis (x) onto a first intermediate image (60),
- a further cylindrical lens (62) located in the light path behind the first intermediate image (60) for focusing the light beams (40a) relative to the first fiber axis (x) onto a second intermediate image (64),
- a cylindrical focusing lens (66) located in the light path behind the second intermediate image (64) for focusing the light beams (40a) relative to the first fiber axis (x) onto the illumination line (44),
an anamorphic homogenizer lens (68) located in the light path behind the cylindrical lens (58) for focusing the light beams (40a) relative to the fiber axis (x) onto the first intermediate image (60) for homogenizing the light beams (40b) emanating from the optical fibers (20) relative to the second fiber axis (x), and/or
- a cylindrical condenser lens (74) located in the light path behind the anamorphic lens (68) for superimposing the homogenized light beams (40b) in the illumination line (44).

12. The optical system according to claim 11, wherein the cylindrical condenser lens (74) is designed so as to guide the homogenized light beams (40b) telecentrically to the illuminating line (44).

13. The optical system according to any one of the preceding claims, wherein each of the optical fibers (20) is designed as a rectangular fiber whose core and/or cladding have a cross-section (26) in rectangular shape with a short rectangle axis and a long rectangle axis.

14. The optical system according to any one of the preceding claims, further comprising a cylindrical-lens-based telescope array (104) including a segmented cylindrical lens (106) comprising several cylindrical lens segments (110) that are adjustable, independently from one another, in the direction of the beam by adjusting means of the cylindrical-lens-based telescope array (104).

15. The optical system according to any one of the preceding claims, further comprising an interference suppression device (116) including several glass blocks 118, 118a, 118b) to form a glass block array (120), wherein the glass blocks (118a) of a first portion of the glass blocks (118, 118a, 118b) arranged in a glass block array (120) have, relative to one another, different geometric lengths (Q1), the glass blocks (118b) of a second portion of the glass blocks (118, 118a, 118b) arranged in the glass block array (120) have, relative to one another, different geometric lengths (Q2), and the geometric length (Q1) of each glass block (118a) in the first portion of the glass block array (120) is longer than the geometric length (Q2) of each glass block (118b) in the second portion of the glass block array (120), wherein the glass blocks (118, 118a, 118b) are arranged in the glass block array (120) such that next to each glass block (118a) of the first portion a glass block (118b) of the second portion is arranged but no other glass block (118a) of the first part.

16. An apparatus (10) for processing thin-film layers, comprising:
- at least one laser (12) for generating a light beam (14),
- a support on which the material layer is applicable or is applied, and
- an optical system (16) according to any one of claims 1 to 15,
wherein the apparatus is constructed and arranged so as to expose the material layer to the light beam (14') that is guided through the majority of optical fibers (20) of the optical system, in order to process the material layer by melting it at least for a short period of time.

## Revendications

1. Système optique (16) pour une installation destinée à traiter des couches de film mince, comprenant
- une pluralité de fibres optiques (20) destinées à guider de la lumière, en particulier de la lumière laser,
- au moins un dispositif d'injection optique (22) pour injecter la lumière dans les fibres optiques (20), et
- un dispositif de représentation optique (24) permettant de générer dans un plan d'éclairage (52) une ligne d'éclairage (44) qui est formée à partir des faisceaux lumineux (14' ; 40 ; 40a, 40b) sortant des fibres optiques (20) et qui présente un axe long et un axe court, chacune des fibres optiques (20) présentant une section rectangulaire avec un axe de fibre court (x) et un axe de fibre long (y), et ledit dispositif de représentation optique (24) comportant un élément d'optique à effet d'anamorphose (42) qui est conçu pour focaliser sur l'axe court de la ligne d'éclairage (44) les faisceaux lumineux (40a, 40b) sortant des fibres optiques (20) par rapport à l'axe de fibre court (x) et pour superposer ceux-ci de manière homogénéisée dans la ligne d'éclairage (44) par rapport à l'axe de fibre long (y).

2. Système optique selon la revendication 1, le dispositif d'injection optique (22) comportant au moins un diviseur de rayon (32) disposé dans la trajectoire d'un faisceau lumineux (14b), lequel diviseur est conçu pour diviser géométriquement le faisceau lumineux (14b) en au moins un premier et un deuxième faisceau lumineux partiel (14c1, 14c2) de telle sorte que le rapport entre l'indice de diffraction M_{L1}² par rapport à un premier axe de faisceau dans le profil du faisceau lumineux partiel (14c1, 14c2) et l'indice de diffraction M_{L2}² par rapport à un deuxième axe de faisceau perpendiculaire au premier axe de faisceau dans le profil du faisceau lumineux partiel (14c1, 14c2) est ajusté à un rapport prédéterminé égal à T= M_{L1}² : M_{L1}², celui-ci étant plus particulièrement de T≈0,5 ou T≈2.

3. Système optique selon la revendication 2, ledit diviseur de rayon (32) présentant au moins une surface miroir (34) dotée d'une arête vive, plus particulièrement droite, cette surface miroir (34) ne faisant que pour autant saillie dans le faisceau lumineux (14b) à partir d'une direction, le long d'un des deux premier et deuxième axes du faisceau lumineux (14b), que la surface miroir (34) ne couvre qu'une partie du premier ou du deuxième axe du faisceau lumineux (14b) dont la longueur est réduite du facteur T en comparaison avec la longueur totale des premier et deuxième axes du faisceau lumineux (14b).

4. Système optique selon l'une des revendications précédentes, le dispositif d'injection optique (22) comportant une optique de collimation et de divergence (28, 30) conçue pour transformer un faisceau lumineux (14) en un faisceau lumineux (14) converti, plus particulièrement collimaté, de telle sorte que le faisceau lumineux (14b) converti présente un profil de faisceau dans lequel la longueur L'_{L1} d'un premier axe de faisceau correspond à une première longueur prédéterminée, et la longueur L'_{L2} d'un deuxième axe de faisceau perpendiculaire au premier axe de faisceau correspond à une deuxième longueur prédéterminée, et/ou la longueur L'_{L1} du premier axe de faisceau par rapport à la longueur L'_{L2} du deuxième axe de faisceau correspond à un rapport d'aspect prédéterminé Y_{L}=L'_{L1} :L'_{L2}, ce rapport d'aspect Y_{L}=L'_{L1} :L'_{L2} dans le profil du faisceau lumineux converti correspondant notamment sensiblement au rapport d'aspect Y_{F}=L'_{F1} : L'_{F2} formé à partir de la longueur L_{F1} d'un premier axe de fibre dans la section transversale (26) d'une fibre optique (20) et de la longueur L_{F2} d'un deuxième axe de fibre perpendiculaire au premier axe de fibre dans la section transversale (26) de la fibre optique (20), soit Y_{L}≈Y_{F}.

5. Système optique selon l'une des revendications précédentes, le dispositif d'injection optique (22) comprenant une optique d'injection (38) pour focaliser un faisceau lumineux (14c1, 14c2) dans une fibre optique (20), ladite optique d'injection (38) étant réalisée plus particulièrement sous la forme d'une lentille asphérique corrigée et dotée d'une distance focale f.

6. Système optique selon l'une des revendications précédentes, une optique de collimation et de divergence (28, 30), un diviseur de rayon (32) et une optique d'injection (38) étant conçus pour injecter les faisceaux lumineux partiels (14c1, 14c2) dans les fibres optiques (20) de telle sorte que la longueur L_{L1} du premier axe de faisceau dans le profil d'un faisceau lumineux partiel (14c1, 14c2) est ajustée à la longueur L_{F1} du premier axe de fibre dans la section transversale (26) d'une fibre optique (20) et que la longueur L_{L2} du deuxième axe de faisceau dans le profil du faisceau lumineux partiel (14c1, 14c2) est ajustée à la longueur LF2 du deuxième axe de fibre dans la section transversale (26) de la fibre optique (20) lors de l'introduction du faisceau lumineux partiel (14c1 14c2) dans la fibre optique (20), notamment L_{L1}=ηxL_{F1} et L_{L1}=ηxL_{F1} avec une valeur prédéterminée égale à 0≤n≤1, par exemple η=60 à 70 %.

7. Système optique selon l'une des revendications précédentes, une optique de collimation et de divergence (28, 30), un diviseur de rayon (32) et une optique d'injection (38) étant conçus pour injecter les faisceaux lumineux partiels (14c1, 14c2) dans les fibres optiques (20) de telle sorte que l'ouverture numérique NA_{L1} par rapport au premier axe d'un faisceau lumineux partiel (14c1, 14c2) correspond à l'ouverture numérique NA_{F} d'une fibre optique (20) ou à une première valeur maximale prédéterminée NA_{max,1}, et que l'ouverture numérique NA_{L2} par rapport au deuxième axe du faisceau lumineux partiel (14c1, 14c2) correspond à l'ouverture numérique NA_{F} de la fibre optique (20) ou à une deuxième valeur maximale prédéterminée NA_{max,2}, notamment NA_{max,1}≈NA_{max,2} ou NA_{max,1}≈2xNA_{max,2} et/ou NA-_{max,1}=0,12.

8. Système optique selon l'une des revendications précédentes, les fibres optiques (20) étant disposées les unes par rapport aux autres de telle sorte que des directions de propagation des faisceaux lumineux (40a, 40b) sortant des fibres optiques (20) sont orientées parallèlement les unes aux autres, et les centres (48) des tailles des faisceaux lumineux (40a, 40b) sortant des fibres optiques (20) étant positionnés le long d'une ligne de référence (50) courbe située dans un plan (y-z) de telle sorte que par rapport à une droite (46) qui s'étend parallèlement aux directions de propagation et passe par le centre de gravité de la ligne de référence (50), les positions axiales des centres (48) sont déplacées dans une direction (z) par rapport à ladite droite (46) et parallèlement à cette dernière à mesure qu'augmentent les distances radiales entre les centres (48).

9. Système optique selon l'une des revendications précédentes, l'optique à effet d'anamorphose (42) et les fibres optiques (20) étant disposées l'une par rapport aux autres de telle sorte que pour chaque fibre optique (20), le faisceau lumineux (40a, 40b) sortant de cette fibre optique (20) est focalisé sur le plan d'éclairage (52) indépendamment de la distance radiale entre le centre (48) de la taille du rayon et l'axe optique (46) de l'optique à effet d'anamorphose (42).

10. Système optique selon l'une des revendications précédentes, des moyens d'ajustage étant prévus et conçus pour ajuster la position dans l'espace des fibres optiques (20) de telle sorte qu'au moins les distances entre les centres (48) des tailles de rayon des faisceaux lumineux (40a, 40b) sortant des fibres optiques (20) peuvent être ajustées indépendamment les unes des autres par rapport à l'optique à effet d'anamorphose (42).

11. Système optique selon l'une des revendications précédentes, l'optique à effet d'anamorphose (42) comprenant :
- une première lentille cylindrique de collimation (54) pour collimater les faisceaux lumineux (40a) sortant des fibres optiques (20) par rapport au premier axe de fibre court (x),
- une deuxième lentille cylindrique de collimation (56) pour collimater les faisceaux lumineux (40b) sortant des fibres optiques (20) par rapport au deuxième axe de fibre (y),
- une lentille cylindrique (58) disposée dans la trajectoire du faisceau, derrière la première lentille cylindrique de collimation (54), pour focaliser les faisceaux lumineux (40a) par rapport au premier axe de fibre (x) sur une première image intermédiaire (60),
- une lentille cylindrique (62) supplémentaire disposée dans la trajectoire du faisceau, derrière la première image intermédiaire (60), pour focaliser les faisceaux lumineux (40a) par rapport au premier axe de fibre (x) sur une deuxième image intermédiaire (64),
- une optique à cylindre de focalisation (66) disposée dans la trajectoire du faisceau, derrière la deuxième image intermédiaire (64), pour focaliser les faisceaux lumineux (40a) par rapport au premier axe de fibre (x) sur la ligne d'éclairage (44),
- une optique d'homogénéisation (68) à effet d'anamorphose disposée dans la trajectoire du faisceau, derrière la lentille cylindrique (58), pour focaliser les faisceaux lumineux (40a) par rapport au premier axe de fibre (x) sur la première image intermédiaire (60) et pour homogénéiser les faisceaux lumineux (40b) sortant des fibres optiques (20) par rapport au deuxième axe de fibre (y) et/ou
- une lentille cylindrique de condenseur (74) disposée dans la trajectoire du faisceau, derrière l'optique d'homogénéisation à effet d'anamorphose (68), pour superposer les faisceaux lumineux (40b) homogénéisés sur la ligne d'éclairage (44).

12. Système optique selon la revendication 11, ladite lentille cylindrique de condenseur (74) étant conçue pour diriger de manière télécentrique les faisceaux lumineux (40b) homogénéisés sur la ligne d'éclairage (44).

13. Système optique selon l'une des revendications précédentes, chacune des fibres optiques (20) étant réalisée sous la forme d'une fibre rectangulaire dont le noyau et/ou la gaine présente une section (26) rectangulaire avec un axe de rectangle court et un axe de rectangle long.

14. Système optique selon l'une des revendications précédentes, comprenant en outre un agencement télescopique à lentille cylindrique (104) doté d'une lentille cylindrique (106) segmentée qui présente plusieurs segments (110) indépendamment ajustables les uns des autres en direction du faisceau, à l'aide de moyens d'ajustage montés sur l'agencement télescopique à lentille cylindrique.

15. Système optique selon l'une des revendications précédentes, comprenant en outre un suppresseur d'interférences (116) comportant plusieurs blocs de verre (118, 118a, 118b) rassemblés pour former un groupe de blocs de verre (120), les blocs de verre (118a) d'une première partie des blocs de verre (118, 118a, 118b) rassemblés pour former un groupe de blocs de verre (120) présentant respectivement des longueurs géométriques (Q1) différentes les unes des autres, les blocs de verre (118b) d'une deuxième partie des blocs de verre (118, 118a, 118b) rassemblés pour former un groupe de blocs de verre (120) présentant chacun des longueurs géométriques (Q2) différentes les unes des autres, et la longueur géométrique (Q1) de chaque bloc de verre (118a) dans la première partie du groupe de blocs de verre (120) étant plus grande que la longueur géométrique (Q2) de chaque bloc de verre (118b) dans la deuxième partie du groupe de blocs de verre (120), et les blocs de verre (118, 118a, 118b) étant disposés en groupe (120) de telle sorte qu'il se trouve dans le voisinage direct de chaque bloc de verre (118a) de la première partie un bloc de verre (118b) de la deuxième partie - et non pas un autre bloc de verre (118a) de la première partie.

16. Installation destinée à traiter des couches de film mince, comprenant :
- au moins un laser (12) destiné à produire un faisceau lumineux (14),
- un support sur lequel peut être ou est appliquée une couche de matériau, et
- un système optique selon l'une des revendications 1 à 15,
l'installation étant conçue et disposée pour permettre l'application de ladite couche de matériau à l'aide d'un faisceau lumineux (14') guidé par la pluralité de fibres optiques (20) du système optique pour transformer la couche de matériau en lui faisant subir pour le moins une brève fusion.
